# EUROPEAN PATENT SPECIFICATION

(11) **EP 3 879 542 B1**
(45) Date of publication and mention of the grant of the patent: **20.11.2024**
(21) Application number: 21161319.5
(22) Date of filing: 08.03.2021
(51) Int. Cl.: H01F 1/37, H05K 1/16, H01F 1/26

(54) **RESIN COMPOSITION**
HARZZUSAMMENSETZUNG
COMPOSITION DE RÉSINE

(30) Priority: 09.03.2020 JP 2020040321
(43) Date of publication of application: 15.09.2021
(73) Proprietor: Ajinomoto Co., Inc., Tokyo 104-8315 (JP)
(72) Inventor: OURA, Ichiro, Kawasaki-shi, Kanagawa 210-0801 (JP); HOMMA, Tatsuya, Kawasaki-shi,, Kanagawa 210-0801 (JP)
(74) Representative: Mewburn Ellis LLP

(56) References cited:
- WO-A1-2019/188344
- WO-A1-2020/022393
- US-A1- 2019 206 597
- US-A1- 2021 024 742

## Description

### BACKGROUND OF THE INVENTION

### 1. Field of the Invention

The present invention relates to a resin composition, as well as a magnetic sheet, a circuit substrate, and an inductor substrate, which are obtained by using the resin composition.

### 2. Description of the Related Art

In some cases, a circuit substrate such as a printed wiring board is provided with a magnetic layer including magnetic powder in an inductor part and the like. In order to suppress reduction of a magnetic loss, for example, Japanese Patent Application Laid-open No. 2019-143241 describes, as the magnetic powder included in the magnetic layer, soft magnetic powder covered with a silicon oxide in which the soft magnetic powder is surface-treated with the silicon oxide.

WO 2020/022393 A1 discloses an inductor component comprising a circuit board formed of a substrate having a through hole and a cured product of a magnetic paste filled in the through hole; wherein the magnetic paste contains a magnetic powder and an epoxy resin; the magnetic powder is at least one selected from an iron oxide powder and iron alloy-based metal powder.

### SUMMARY OF THE INVENTION

In order to further enhance performance of the inductor part, a technology capable of forming a magnetic layer having a low magnetic loss is required. The inventors of the present invention have studied a relative permeability and the magnetic loss in the magnetic layer. It has been found that as the relative permeability is increased, the magnetic loss increases, on the other hand, as the magnetic loss is decreased, the relative permeability decreases; namely, there is a trade-off relation between the relative permeability and the magnetic loss.

In light of these circumstances, the present invention has an object to provide a resin composition capable of producing a cured product having an enhanced relative permeability and a lowered magnetic loss and provide a magnetic sheet, a circuit substrate, and an inductor substrate, all being obtained by using this resin composition.

The inventors of the present invention have carried out an extensive investigation and found that when a resin composition includes a plurality of magnetic powders having different compact powder resistances, the trade-off relation between the relative permeability and the magnetic loss can be dissolved; in particular, the decrease in the magnetic loss is significant. The present invention was completed on the basis of these findings.

Namely, the present invention includes a resin composition as defined in independent claim 1, a magnetic sheet as defined in independent claim 9, a circuit substrate as defined in independent claims 10 and 11, and an inductor substrate as defined in independent claim 12. Optional features are defined in the dependent claims.

According to the present invention, provided are: a resin composition capable of producing a cured product having an enhanced relative permeability and a lowered magnetic loss; and a magnetic sheet, a circuit substrate, and an inductor substrate, all being obtained by using this resin composition.

### BRIEF DESCRIPTION OF THE DRAWINGS

Fig. 1 is a schematic sectional view of the core substrate, as one example of the production method of a circuit substrate according to a first embodiment;
Fig. 2 is a schematic sectional view of the core substrate having a through hole formed therein, as one example of the production method of a circuit substrate according to the first embodiment;
Fig. 3 is a schematic sectional view illustrating the core substrate having a plated layer in the through hole, as one example of the production method of a circuit substrate according to the first embodiment;
Fig. 4 is a schematic sectional view illustrating the core substrate having a magnetic paste filled in the through hole, as one example of the production method of a circuit substrate according to the first embodiment;
Fig. 5 is a schematic sectional view illustrating the core substrate having the filled magnetic paste thermally cured, as one example of the production method of a circuit substrate according to the first embodiment;
Fig. 6 is a schematic sectional view illustrating the core substrate after a cured product is polished, as one example of the production method of a circuit substrate according to the first embodiment;
Fig. 7 is a schematic sectional view illustrating the core substrate having a conductive layer formed on a polished surface, as one example of the production method of a circuit substrate according to the first embodiment;
Fig. 8 is a schematic sectional view illustrating the core substrate having a patterned conductive layer formed, as one example of the production method of a circuit substrate according to the first embodiment;
Fig. 9 is a schematic sectional view to explain the process (A) included in one example of the production method of a circuit substrate according to a second embodiment;
Fig. 10 is a schematic sectional view to explain the process (A) included in one example of the production method of a circuit substrate according to the second embodiment;
Fig. 11 is a schematic sectional view to explain the process (B) included in one example of the production method of a circuit substrate according to the second embodiment;
Fig. 12 is a schematic sectional view to explain the process (D) included in one example of the production method of a circuit substrate according to the second embodiment;
Fig. 13 is a schematic plane view observed from one direction in thickness directions of the inductor part that includes the circuit substrate obtained by one example of the production method of a circuit substrate according to the second embodiment;
Fig. 14 is a schematic plane view illustrating a cut edge face of the inductor substrate that is cut at the place indicated by the II-II one dot chain line as illustrated in Fig. 13; the inductor substrate including the circuit substrate obtained by one example of the production method of a circuit substrate according to the second embodiment;
Fig. 15 is a schematic plane view to explain a composition of the first conductive layer in the inductor part that includes the circuit substrate obtained as one example of the production method of a circuit substrate according to the second embodiment; and
Fig. 16 is a graph illustrating the results of the relative permeability and the magnetic loss in Examples 1 to 4 and Comparative Examples 1 to 2.

### DETAILED DESCRIPTION OF THE PREFERRED EMBODIMENTS

Hereinafter, with referring to the drawings, embodiments of the present invention will be explained. In these drawings, the shape, size, and arrangement of the composition elements are roughly illustrated so as to merely help to understand the present invention. The present invention is not limited by the embodiments described below, and thus, each of the composition elements may be arbitrarily changed. In addition, the compositions relating to the embodiments of the present invention are not necessarily produced or used in accordance with the arrangements illustrated in the drawings.

### Resin Composition

The resin composition of the present invention includes (A-1) a magnetic powder having a powder compacting resistance within the range of 1.0×10⁵ to 1.0×10¹³ Ω·cm both ends inclusive, (A-2) a magnetic powder having a powder compacting resistance within the range of 10 to 1.0×10⁴ Ω·cm both ends inclusive, and (B) a resin component. In the present invention, because the resin composition is made to include the (A-1) component and the (A-2) component which are magnetic powders having different powder compacting resistances, both enhancement of the relative permeability and the reduction of the magnetic loss of a cured product of the resin composition can be compatibly satisfied.

The resin composition can further include (C) other additive, as needed. Hereinafter, each component included in the resin composition of the present invention will be explained in detail. The (A-1) component and the (A-2) component are sometimes collectively called "(A) component".

<(A-1) Magnetic powder having a powder compacting resistance within the range of 1.0×10⁵ to 1.0×10¹³ Ω·cm both ends inclusive and (A-2) magnetic powder having a powder compacting resistance within the range of 10 to 1.0×10⁴ Ω·cm both ends inclusive>

The resin composition includes, as the (A-1) component, the magnetic powder having a powder compacting resistance within the range of 1.0×10⁵ to 1.0×10¹³ Ω·cm both ends inclusive, and as the (A-2) component, the magnetic powder having a powder compacting resistance within the range of 10 to 1.0×10⁴ Ω·cm both ends inclusive. When the resin composition is made to include the (A-1) component and the (A-2) component as a combination thereof, both the enhancement of the relative permeability and the reduction of the magnetic loss of the cured product thereof can be compatibly satisfied. In each of the (A-1) component and the (A-2) component, one kind of the magnetic powder may be used, or two or more different kinds of the magnetic powder may be used concurrently.

In this specification, the powder compacting resistance is a volume resistivity of a compressed powder body measured by a resistivity measurement instrument at 25°C and humidity of 50%; the compressed powder body being obtained by press-molding 5 g of the magnetic powder, filled in a measurement container, with a load of 4 kN. Specifically, the powder compacting resistance may be measured by the method described in Examples to be described later.

The powder compacting resistance of the (A-1) component is 1.0×10⁵ Ω·cm or more, and preferably 2.0×10⁵ Ω·cm or more, while more preferably 3.0×10⁵ Ω·cm or more. The upper limit thereof is 1.0×10¹³ Ω·cm or less, and preferably 1.0×10¹¹ Ω·cm or less, while more preferably 1.0×10¹⁰ Ω·cm or less. When the powder compacting resistance is brought into this range, the relative permeability thereof can be enhanced.

The powder compacting resistance of the (A-2) component is 10 Ω·cm or more, and preferably 1.0×10² Ω·cm or more, while more preferably 2.0×10² Ω·cm or more. The upper limit thereof is 1.0×10⁴ Ω·cm or less, and preferably 2.0×10³ Ω·cm or less, while more preferably 1.0×10³ Ω·cm or less. When the compact powder resistance is brought into this range, the magnetic loss thereof can be decreased.

When the content (% by volume) of the (A-1) component is designated by a1 based on 100% by volume as a total volume of the (A-1) component and the (A-2) component, and when the content (% by volume) of the (A-2) component is designated by a2 based on 100% by volume as the total volume of the (A-1) component and the (A-2) component, a1/a2 is 0.10 or more, and preferably 0.50 or more, more preferably 1.00 or more, and 5.00 or less, and preferably 4.00 or less, more preferably 3.00 or less. When a1/a2 is brought into this range, both the enhancement of the relative permeability and the reduction of the magnetic loss can be compatibly satisfied.

According to the investigation by the present inventors, it has been found that a larger amount of the (A-1) component having a higher powder compacting resistance leads to a tendency that the magnetic loss can be decreased but the relative permeability decreases. It has also been found that a larger amount of the (A-2) component having a lower powder compacting resistance leads to a tendency that the relative permeability can be increased but the magnetic loss increases. Thus, in the present invention, by combining the (A-1) component and the (A-2) component, compatibility of the enhancement of the relative permeability and the reduction of the magnetic loss is achieved. In addition, according to the investigation of the present inventors, it has been surprisingly found that when the content ratio of the (A-1) component to the (A-2) component is changed, the magnetic loss changes non-linearly. On the basis of these findings, the range of the ratio a1/a2 was determined so as to obtain the unexpected and significant effect due to this nonlinear change.

The total content (% by volume) of the (A-1) component and the (A-2) component is preferably 30% or more by volume, more preferably 40% or more by volume, and still more preferably 50% or more by volume, while far more preferably 55% or by volume, and preferably 80% or less by volume, and more preferably 75% or less by volume, while still more preferably 70% or less by volume, relative to 100% by volume of non-volatile components in the resin composition. When the total content of the (A-1) component and the (A-2) component is brought into this range, both the enhancement of the relative permeability and the reduction of the magnetic loss can be compatibly satisfied.

From a viewpoint to increase the relative permeability, the content (% by mass) of the (A-1) component is preferably 5% or more by mass, and more preferably 10% or more by mass, while still more preferably 20% or more by mass, 30% or more by mass, or 40% or more by mass, relative to 100% by mass of the non-volatile components in the resin composition. Also, the content is preferably 98% or less by mass, and more preferably 95% or less by mass, while still more preferably 90% or less by mass.

In the present invention, the content of each component in the resin composition is on the basis of 100% by mass as the non-volatile components in the resin composition unless otherwise specifically mentioned.

From a viewpoint to decrease the magnetic loss, the content (% by mass) of the (A-2) component is preferably 2% or more by mass, and more preferably 5% or more by mass, while still more preferably 10% or more by mass, relative to 100% by mass of the non-volatile components in the resin composition. Also, the content is preferably 95% or less by mass, and more preferably 90% or less by mass, while still more preferably 80% or less by mass, 70% or less by mass, or 60% or less by mass.

From a viewpoint to compatibly satisfy both the enhancement of the relative permeability and the reduction of the magnetic loss, the total content (% by mass) of the (A-1) component and the (A-2) component is preferably 60% or more by mass, and more preferably 70% or more by mass, while still more preferably 80% or more by mass, relative to 100% by mass of the non-volatile components in the resin composition. Also, the total content is preferably 98% or less by mass, and more preferably 95% or less by mass, while still more preferably 90% or less by mass.

The (A-1) component and the (A-2) component may be any of the soft magnetic powder and the hard magnetic powder. From a viewpoint to significantly obtain the effects of the present invention, the soft magnetic powder is preferable.

The (A-1) component is the Mn-based ferrite; the (A-2) component is at least one kind selected from the Mn-Zn-based ferrite, the Fe-Ni-based alloy, and the Fe-Si-based alloy, and the Mn-Zn-based ferrite is preferable.

Commercially available products may be used as the (A-1) component, in which two or more of them may be used concurrently. Specific examples of the commercially available usable magnetic powder include M-series products such as "M05S" (manufactured by Powdertech Co., Ltd.) and "Z10FG" (manufactured by Japan Metals and Chemicals Co., Ltd.).

Commercially available products may be used as the (A-2) component, in which two or more of them may be used concurrently. Specific examples of the commercially available usable magnetic powder include: "Z05" manufactured by Powdertech Co., Ltd.; "MZ05" manufactured by Powdertech Co., Ltd.; "PST-S" manufactured by Sanyo Special Steel Co., Ltd.; "AW2-08", "AW2-08PF20F", "AW2-08PF10F", "AW2-08PF3F", "AW08PF10F", "Fe-3.5Si-4.5CrPF20F", "Fe-50%NiPF10F", "Fe-50NiPF20F", and "Fe-80Ni-4MoPF20F" all of which are manufactured by Epson Atmix Corp.; "LD-M", "LD-MH", "KNI-106", "KNI-106GSM", "KNI-106GS", "KNI-109", "KNI-109GSM", and "KNI-109GS" all of which are manufactured by JFE Chemical Corp.; "KNS-415", "BSF-547", "BSF-029", "BSN-125", "BSN-714", "BSN-828", "S-1281", "S-1641", "S-1651", "S-1470", "S-1511", and "S-2430" all of which are manufactured by Toda Kogyo Corp.; "JR09P2" manufactured by Japan Metals and Chemicals Co., Ltd.; "Nanotek" manufactured by CIK-NanoTek Corp.; "JEMK-S" and "JEMK-H" which are manufactured by Kinsei Matec Co., Ltd.; and "Yttrium iron oxide" manufactured by Aldrich Corp..

The (A-1) component and the (A-2) component are preferably spherical. The value that is obtained by dividing a long axis with a short axis of the magnetic powder (namely, aspect ratio) is preferably 2 or less, and more preferably 1.5 or less, while still more preferably 1.2 or less. In general, the magnetic powder in a flat shape can have a higher relative permeability than the magnetic powder in a spherical shape. On the other hand, in particular, the use of the spherical magnetic powder can usually lead to a low magnetic loss, and is preferable from a viewpoint to obtain the resin composition having a preferable viscosity.

From a viewpoint to increase the relative permeability, the average particle diameter of the (A-1) component and the (A-2) component is preferably 0.01 um or more, and more preferably 0.5 um or more, while still more preferably 1 um or more. Also, the average particle diameter is preferably 10 um or less, and more preferably 9 µm or less, while still more preferably 8 µm or less.

The average particle diameter of the (A-1) component and the (A-2) component may be measured with a laser diffraction/scattering method based on the Mie scattering theory. Specifically, the particle diameter distribution of the magnetic powder on the volume basis is prepared by using a laser diffraction scattering type particle diameter distribution measurement apparatus, and the median diameter thus obtained is taken as the average particle diameter thereof. The measurement sample that is obtained by dispersing the magnetic powders in water by means of an ultrasonic wave is preferably used. Illustrative examples of the laser diffraction and scattering type particle diameter distribution measurement apparatus that can be used include "LA-960" manufactured by Horiba Ltd. and "SALD-2200" manufactured by Shimadzu Corp.

From a viewpoint to increase the relative permeability, a specific surface area of the (A-1) component and the (A-2) component is preferably 0.05 m²/g or more, and more preferably 0.1 m²/g or more, while still more preferably 0.3 m²/g or more. Also the specific surface area is preferably 10 m²/g or less, and more preferably 8 m²/g or less, while still more preferably 5 m²/g or less. The specific surface area of the (A) component may be measured by a BET method.

From a viewpoint to increase the relative permeability, the true specific gravity of the (A-1) component and the (A-2) component is preferably 1.0 g/cm³ or more, and more preferably 3.0 g/cm³ or more, while still more preferably 4.0 g/cm³ or more. Also, the true specific gravity is preferably 10.0 g/cm³ or less, and more preferably 9.0 g/cm³ or less, while still more preferably 8.0 g/cm³ or less. The true specific gravity may be measured by a gas volume method. Specifically, the volume of the magnetic powder weighed by an electronic balance is measured by the method in accordance with JIS M8717 by using a helium gas with a dry type automatic densitometer ("AccuPyc II1340 10CC", manufactured by Shimadzu Corp.), and then, the true specific gravity value is obtained by dividing the weight of the magnetic powder with the volume of the magnetic powder.

From a viewpoint to adjust the viscosity of the resin composition and enhance the humidity resistance and the dispersion property, the (A-1) component and the (A-2) component may be treated with a surface treatment agent. Illustrative examples of the surface treatment agent include a vinylsilane type coupling agent, a (meth)acryl type coupling agent, a fluorine-containing silane coupling agent, an aminosilane type coupling agent, an epoxy silane type coupling agent, a mercapto silane type coupling agent, a silane type coupling agent, an alkoxy silane, an organosilazane compound, and a titanate type coupling agent. These surface treatment agents may be used singly or as an arbitrary combination of two or more of them.

Illustrative examples of the commercially available surface treatment agent include "KBM1003" (vinyl triethoxy silane) manufactured by Shin-Etsu Chemical Co., Ld.; "KBM503" (3-methacryloxy propyl triethoxy silane) manufactured by Shin-Etsu Chemical Co., Ld.; "KBM403" (3-glycidoxy propyl trimethoxy silane) manufactured by Shin-Etsu Chemical Co., Ld., "KBM803" (3-mercaptopropyl trimethoxy silane) manufactured by Shin-Etsu Chemical Co., Ld.; "KBE903" (3-aminopropyl triethoxy silane) manufactured by Shin-Etsu Chemical Co., Ld.; "KBM573" (N-phenyl-3-aminopropyl trimethoxy silane) manufactured by Shin-Etsu Chemical Co., Ld.; "SZ-31" (hexamethyl disilazane) manufactured by Shin-Etsu Chemical Co., Ld.; "KBM103" (phenyl trimethoxy silane) manufactured by Shin-Etsu Chemical Co., Ld.; "KBM-4803" (long chain epoxy type silane coupling agent) manufactured by Shin-Etsu Chemical Co., Ld.; and "KBM-7103" (3,3,3-trifluoropropyl trimethoxy silane) manufactured by Shin-Etsu Chemical Co., Ld.

From a viewpoint to enhance the dispersion property of the (A) component, the degree of the surface treatment by means of the surface treatment agent is preferably within a prescribed range. Specifically, the (A) component is surface-treated by the surface treatment agent with the amount of preferably 0.01 to 5 parts by mass, preferably 0.05 to 3 parts by mass, and preferably 0.1 to 2 parts by mass, relative to 100 parts by mass of the (A) component.

### <(B) Resin Composition>

The resin composition includes (B) the resin component as the (B) component. Illustrative examples of (B) the resin component include (B-1) a thermosetting resin, (B-2) a curing accelerator, and (B-3) a dispersant. Preferably, the (B) component includes (B-1) the thermosetting resin, while more preferably (B-1) the thermosetting resin and (B-2) the curing accelerator.

### -- (B-1) Thermosetting Resin -

The (B) component may include (B-1) the thermosetting resin. When the resin composition is made to include the (B-1) component, a cured product that is excellent in mechanical characteristics and magnetic characteristics can be obtained.

Illustrative examples of (B-1) the thermosetting resin that can be used include the thermosetting resin that is used in formation of an insulating layer of a wiring board. Illustrative examples of the thermosetting resin like this include an epoxy resin, a phenol type resin, a naphthol type resin, a benzoxazine type resin, an active ester type resin, a cyanate ester type resin, a carbodiimide type resin, an amine type resin, and an acid anhydride type resin. Among these, the resin composition including the epoxy resin or the phenol type resin is preferable, while the resin composition including the epoxy resin is more preferable.

(B-1) These thermosetting resin may be used singly, or as a combination of two or more of those mentioned above. Note that the components capable of curing the resin composition by reacting with an epoxy resin, i.e., the components such as the phenol type resin, the naphthol type resin, the benzoxazine type resin, the active ester type resin, the cyanate ester type resin, the carbodiimide type resin, the amine type resin, and the acid anhydride type resin, are sometimes collectively called "curing agent".

Illustrative examples of the epoxy resin include: a glycyrol type epoxy resin; a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolak type epoxy resin; a tert-butyl-catechol type epoxy resin; epoxy resins having a condensed cyclic structure such as a naphthol novolak type epoxy resin, a naphthalene type epoxy resin, a naphthol type epoxy resin, and an anthracene type epoxy resin; a glycidyl ether type epoxy resin; a glycidyl amine type epoxy resin; a glycidyl ester type epoxy resin; a cresol novolak type epoxy resin; a biphenyl type epoxy resin; a linear aliphatic epoxy resin; an epoxy resin having a butadiene structure; an alicyclic epoxy resin; a heterocyclic epoxy resin; an epoxy resin having a spiro ring; a cyclohexane dimethanol type epoxy resin; a trimethylol type epoxy resin; and a tetraphenylethane type epoxy resin. These epoxy resins may be used singly or as a combination of two or more of them. The epoxy resin is preferably one or more epoxy resins selected from the bisphenol A type epoxy resin, the bisphenol F type epoxy resin, and the glycidyl ether type epoxy resin.

It is preferable that the epoxy resin include an epoxy resin having two or more epoxy groups in one molecule. In addition, the epoxy resin having an aromatic structure is preferable. When two or more of the epoxy resins are used, it is more preferable that at least one of them have an aromatic structure. The aromatic structure means a chemical structure generally defined as aromatic, and this includes a polycyclic aromatic and an aromatic heterocycle. The ratio of the epoxy resin having two or more epoxy groups in one molecule relative to 100% by mass of the non-volatile components in the epoxy resin is preferably 50% or more by mass, and more preferably 60% or more by mass, while especially preferably 70% or more by mass.

As for the epoxy resin, there are an epoxy resin that is in a liquid state at 25°C (hereinafter, this is also called "liquid epoxy resin") and an epoxy resin that is in a solid state at 25°C (hereinafter, this is also called "solid epoxy resin"). When the resin composition includes the epoxy resin as the (B-1) component, the resin composition may include, as the epoxy resin, only the liquid epoxy resin, or only the solid epoxy resin, or the liquid epoxy resin and the solid epoxy resin as combination of them. In particular, from a viewpoint to lower the viscosity of the resin composition, preferably only the liquid epoxy resin is included therein.

The liquid epoxy resin is preferably a glycyrol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl ether type epoxy resin, a glycidyl amine type epoxy resin, a phenol novolak type epoxy resin, an alicyclic epoxy resin having an ester skeleton, a cyclohexane dimethanol type epoxy resin, and an epoxy resin having a butadiene structure. Among these, the glycidyl ether type epoxy resin, the bisphenol A type epoxy resin, and the bisphenol F type epoxy resin are more preferable. Specific examples of the liquid epoxy resin include: "HP4032", "HP4032D", and "HP4032SS" (all are naphthalene type epoxy resins) manufactured by DIC Corp.; "828US" and "jER828EL" (both resins are bisphenol A type epoxy resins), "jER807" (a bisphenol F type epoxy resin), and "jER152" (a phenol novolak type epoxy resin), all of these resins being manufactured by Mitsubishi Chemical Corp.; "630" (a glycidyl ether type aromatic epoxy resin) and "630LSD", both resins being manufactured by Mitsubishi Chemical Corp.; "ED-523T" (a glycyrol type epoxy resin (Adeka glycyrol)), "EP-3980S" (a glycidyl amine type epoxy resin), and "EP-4088S" (a dicyclopentadiene type epoxy resin), all of these resins being manufactured by ADEKA Corp.; "ZX1059" (mixture of a bisphenol A type epoxy resin and a bisphenol F type epoxy resin) manufactured by Nippon Steel Chemical & Material Co., Ltd.; "EX-721" (a glycidyl ester type epoxy resin) manufactured by Nagase ChemteX Corp.; "Celloxide-2021P" (an alicyclic epoxy resin having an ester skeleton) and "PB-3600" (an epoxy resin having a butadiene structure), both resins being manufactured by Daicel Corp.; and "ZX1658" and "ZX1658GS" (liquid 1,4-glycidyl cyclohexane) both resins being manufactured by Nippon Steel Chemical & Material Co., Ltd. These may be used singly or as a combination of two or more of them.

The solid epoxy resin is preferably a naphthalene type 4-functional epoxy resin, a cresol novolak type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin. Specific examples of the solid epoxy resin include: "HP4032H" (a naphthalene type epoxy resin), "HP-4700" and "HP-4710" (both are naphthalene type 4-functional epoxy resins); "N-690" (a cresol novolak type epoxy resin), "N-695" (a cresol novolak type epoxy resin), "HP-7200", "HP-7200HH", and "HP-7200H" (all are dicyclopentadiene type epoxy resins), "EXA-7311", "EXA-7311-G3", "EXA-7311-G4", "EXA-7311-G4S", and "HP6000" (all are naphthalene ether type epoxy resins), all of these resins being manufactured by DIC Corp.; "EPPN-502H" (a trisphenol type epoxy resin), "NC7000L" (a naphthol novolak type epoxy resin), and "NC3000H", "NC3000", "NC3000L", and "NC3100" (all are biphenyl type epoxy resins), all of these resins being manufactured by Nippon Kayaku Co., Ltd.; "ESN475V" (a naphthalene type epoxy resin) and "ESN485" (a naphthol novolak type epoxy resin), both being manufactured by Nippon Steel Chemical & Material Co., Ltd.; "YX4000H" and "YL6121" (both are biphenyl type epoxy resins), "YX4000HK" (a bixylenol type epoxy resin), and "YX8800" (an anthracene type epoxy resin), all of them being manufactured by Mitsubishi Chemical Corp.; "PG-100" and "CG-500", both being manufactured by Osaka Gas Chemicals Co., Ltd.; and "YL7760" (a bisphenol AF type epoxy resin), "YL7800" (a fluorene type epoxy resin), "jER1010" (a solid bisphenol A type epoxy resin), and "jER1031S" (a tetraphenylethane type epoxy resin), all of them being manufactured by Mitsubishi Chemical Corp. These may be used singly or as a mixture of two or more of them.

When the liquid epoxy resin and the solid epoxy resin are concurrently used as the (B-1) component, the ratio of them (liquid epoxy resin:solid epoxy resin) is, as the mass ratio, preferably in the range of 1:0.1 to 1:4, and more preferably in the range of 1:0.3 to 1:3.5, while still more preferably in the range of 1:0.6 to 1:3. When the ratio of the liquid epoxy resin and the solid epoxy resin is within this range, the intended advantageous effects of the present invention can be clearly obtained.

The epoxy equivalent of the epoxy resin as the (B-1) component is preferably in the range of 50 to 5,000 g/eq., more preferably in the range of 50 to 3,000 g/eq., and still more preferably in the range of 80 to 2,000 g/eq., while far still more preferably in the range of 110 to 1,000 g/eq. Within this range, the crosslinking density of a cured product is sufficient, so that a magnetic layer having a low surface roughness can be obtained. The epoxy equivalent, which is a mass of the resin including one equivalent of the epoxy group, can be measured with a method in accordance with JIS K7236.

The weight-average molecular weight of the epoxy resin as the (B-1) component is preferably in the range of 100 to 5,000, and more preferably in the range of 250 to 3,000, while still more preferably in the range of 400 to 1,500. Note that the weight-average molecular weight of the epoxy resin is the weight-average molecular weight in terms of polystyrene measured with a gel permeation chromatography (GPC) method.

As the active ester type resin, resins having one or more active ester groups in one molecule thereof can be used. Among the active ester type resins like this, resins having two or more highly reactive ester groups in one molecule thereof are preferable as the active ester curing agent, these including a phenol ester type, a thiophenol ester type, an N-hydroxyamine ester type, and a heterocyclic hydroxy compound ester type. The active ester type resin is preferably the compound that is obtained by condensation reaction of a carboxylic acid compound and/or a thiocarboxylic acid compound with a hydroxy compound and/or a thiol compound. Especially, in view of enhancement of a heat resistance, an active ester type resin obtained from a carboxylic acid compound and a hydroxy compound is preferable, while an active ester type resin obtained from a carboxylic acid compound and a phenol compound and/or a naphthol compound is more preferable.

Illustrative examples of the carboxylic acid include benzoic acid, acetic acid, succinic acid, maleic acid, itaconic acid, phthalic acid, isophthalic acid, terephthalic acid, and pyromellitic acid.

Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzene triol, a dicyclopentadiene type diphenol compound, and phenol novolak. Here, "dicyclopentadiene type diphenol compound" means the diphenol compound obtained by condensation of one dicyclopentadiene molecule with two phenol molecules.

Specific examples of the preferable active ester type resin include an active ester type resin containing a dicyclopentadiene type diphenol structure, an active ester type resin containing a naphthalene structure, an active ester type resin containing an acetylated phenol novolak, and an active ester type resin containing a benzoylated phenol novolak. Among them, the active ester type resin containing a naphthalene structure and the active ester type resin containing a dicyclopentadiene type diphenol structure are preferable. Here, "dicyclopentadiene type diphenol structure" means the divalent structure unit formed of phenylene-dicyclopentylene-phenylene.

Illustrative examples of the commercially available active ester type resin include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (all are manufactured by DIC Corp.); active ester type resins containing a naphthalene structure, such as "EXB9416-70BK", "EXB-8100L-65T", "EXB-8150L-65T", and "EXB-8150-62T" (all are manufactured by DIC Corp.); active ester type resins containing an acetylated phenol novolak, such as "DC808" (manufactured by Mitsubishi Chemical Corp.); active ester type resins containing a benzoylated phenol novolak, such as "YLH1026" (manufactured by Mitsubishi Chemical Corp.); active ester type resins as an acetylated phenol novolak, such as "DC808" (manufactured by Mitsubishi Chemical Corp.); and active ester type resins as a benzoylated phenol novolak, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

As the phenol type resin and the naphthol type resin, in view of the heat resistance and the water resistance, resins having a novolak structure are preferable. In view of adhesion with a conductive layer, the biphenyl type resin, the naphthalene type resin, the naphthylene ether type resin, the phenol novolak type resin, and the phenol type curing agent having a triazine skeleton are preferable.

Specific examples of the phenol type resin and the naphthol type resin include "MEH-7700", "MEH-7810", and "MEH-7851" all being manufactured by Meiwa Plastic Industries, Ltd.; "NHN", "CBN", and "GPH" all being manufactured by Nippon Kayaku Co., Ltd.; "SN170", "SN180", "SN190", "SN475", "SN485", "SN495", "SN-495V", "SN375", and "SN395" all being manufactured by Nippon Steel Chemical & Material Co., Ltd.; and "EXB9500", "EXB-6000", "TD-2090", "LA-7052", "LA-7054", "LA-1356", "LA-3018", and "EXB-9500" all being manufactured by DIC Corp.

Specific examples of the benzoxazine type resin include "JBZ-OD100" (benzoxazine ring equivalent of 218 g/eq.), "JBZ-OP100D" (benzoxazine ring equivalent of 218 g/eq.), and "ODA-BOZ" (benzoxazine ring equivalent of 218 g/eq.) all being manufactured by JFE Chemical Corp.; "P-d" (benzoxazine ring equivalent of 217 g/eq.) and "F-a" (benzoxazine ring equivalent of 217 g/eq.), both being manufactured by Shikoku Chemicals Corp.; and "HFB2006M" (benzoxazine ring equivalent of 432 g/eq.) manufactured by Showa Highpolymer Co., Ltd.

Illustrative examples of the cyanate ester type resin include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene)[benzene, bis(4-cyanatephenyl) thioether, and bis(4-cyanatephenyl) ether; polyfunctional cyanate resins derived from a phenol novolak, a cresol novolak, and the like; and a prepolymer in which these cyanate resins are partially made to triazine. Specific examples of the cyanate ester type resin include "PT30" and "PT60" (both are phenol novolak type polyfunctional cyanate ester resins); "ULL-950S" (a polyfunctional cyanate ester); "BA230" and "BA230S75" (prepolymers in which part or all of bisphenol A dicyanate is made to triazine so as to be a trimer), all of these being manufactured by Lonza Japan Ltd.

Specific examples of the carbodiimide type resin include Carbodilite (registered trade mark) V-03 (carbodiimide equivalent of 216 g/eq.), V-05 (carbodiimide equivalent of 262 g/eq.), V-07 (carbodiimide equivalent of 200 g/eq.), and V-09 (carbodiimide equivalent of 200 g/eq.) all being manufactured by Nisshinbo Chemical, Inc.; and Stabaxol (registered trade mark) P (carbodiimide equivalent of 302 g/eq.) manufactured by Rhein Chemie GmbH.

The amine type resin can be the resin having one or more amino groups in one molecule thereof. Illustrative examples thereof include an aliphatic amine, a polyether amine, an alicyclic amine, and an aromatic amine. Among them, in view of expressing the intended effects of the present invention, an aromatic amine is preferable. The amine type resin is preferably a primary amine and a secondary amine, while a primary amine is more preferable. Specific examples of the amine curing agent include 4,4'-methylene bis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylene diamine, m-xylylene diamine, diethyltoluene diamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethane diamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof include "KAYABOND C-200S", "KAYABOND C-100", "KAYAHARD A-A", "KAYAHARD A-B", and "KAYAHARD A-S" all being manufactured by Nippon Kayaku Co. Ltd., as well as "Epicure W" manufactured by Mitsubishi Chemical Corp.

The acid anhydride type resin may be those having one or more acid anhydride groups in one molecule thereof. Specific examples of the acid anhydride type resin include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid.

When the epoxy resin and a curing agent are included in the (B-1) component, the ratio of the epoxy resin to all the curing agents, in terms of the ratio of [total number of the epoxy groups in the epoxy resin] to [total number of the reactive groups in the curing agent], is preferably in the range of 1:0.01 to 1:5, and more preferably in the range of 1:0.5 to 1:3, while still more preferably in the range of 1:1 to 1:2. Note that, "the number of the epoxy groups in the epoxy resin" means the total value of the values obtained by dividing the mass of the non-volatile components of the epoxy resin that is present in the resin composition with the epoxy equivalent. "The number of the reactive groups in the curing agent" means the total value of the values obtained by dividing the mass of the non-volatile components of the curing agent that is present in the resin composition with the equivalent of the reactive group.

When (B-1) the thermosetting resin is included as the (B) component, from a viewpoint to obtain the cured product that is excellent in the mechanical characteristics and the magnetic characteristics, the content of (B-1) the thermosetting resin is preferably 1% or more by mass, and more preferably 5% or more by mass, while still more preferably 10% or more by mass, relative to 100% by mass of the non-volatile components in the resin composition. Although the upper limit thereof is not particularly restricted so far as the effects of the present invention can be expressed, this is preferably 30% or less by mass, and more preferably 25% or less by mass, while still more preferably 20% or less by mass.

### -- (B-2) Curing Accelerator --

The (B) component may include (B-2) the curing accelerator. Illustrative examples of the curing accelerator include a phosphorous type curing accelerator, an amine type curing accelerator, an imidazole type curing accelerator, a guanidine type curing accelerator, and a metal type curing accelerator. Among these, the phosphorous type curing accelerator, the amine type curing accelerator, the imidazole type curing accelerator, and the metal type curing accelerator are preferable. More preferable are the amine type curing accelerator, the imidazole type curing accelerator, and the metal type curing accelerator; the imidazole type curing accelerator is still more preferable. The curing accelerator (B-2) may be used singly, or as a combination of two or more of those mentioned above.

Illustrative examples of the phosphorous type curing accelerator include triphenyl phosphine, a phosphonium borate compound, tetraphenyl phosphonium tetraphenyl borate, n-butyl phosphonium tetraphenyl borate, a tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and a tetrabutyl phosphonium decanoate salt are preferable.

Illustrative examples of the amine type curing accelerator include: trialkyl amines such as triethyl amine and tributyl amine; and 4-dimethylaminopyridine, benzyl dimethyl amine, 2,4,6-tris(dimethylaminomethyl)phenol, and 1,8-diazabicyclo(5,4,0)-undecene. Among these, 4-dimethylaminopyridine and 1,8-diazabicyclo(5,4,0)-undecene are preferable.

Illustrative examples of the imidazole type curing accelerator include imidazole compounds such as 2,4-diamino-6-[2'-methylimidazolyl-(1')]-ethyl-s-triazine, 2-methyl imidazole, 2-undecyl imidazole, 2-heptadecyl imidazole, 1,2-dimethyl imidazole, 2-ethyl-4-methyl imidazole, 1,2-dimethyl imidazole, 2-ethyl-4-methyl imidazole, 2-phenyl imidazole, 2-phenyl-4-methyl imidazole, 1-bezyl-2-methyl imidazole, 1-benzyl-2-phenyl imidazole, 1-cyanoethyl-2-methyl imidazole, 1-cyanoethyl-2-undecyl imidazole, 1-cyanoethyl-2-ethyl-4-methyl imidazole, 1-cyanoethyl-2-phenyl imidazole, 1-cyanoethyl-2-undecyl imidazolium trimellitate, 1-cyanoethyl-2-phenyl imidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethyl imidazole, 2-phenyl-4-methyl-5-hydroxymethyl imidazole, 2,3-dihydro-1H-pyrro[1,2-a]benzimidazole, 1-dodecyl-2-methyl-3-benzyl imidazolium chloride, 2-methyl imidazoline, and 2-phenyl imidazoline; and adducts of these imidazole compounds with an epoxy resin. Among these, 2,4-diamino-6-[2'-methylimidazolyl-(1')]-ethyl-s-triazine, 2-ethyl-4-methyl imidazole, and 1-benzyl-2-phenyl imidazole are preferable, while 2,4-diamino-6-[2'-methylimidazolyl-(1')]-ethyl-s-triazine is more preferable.

As for the imidazole type curing accelerator, commercially available products thereof may be used. Illustrative examples thereof include "2P4MZ" manufactured by Shikoku Chemicals Corp. and "P200-H50" manufactured by Mitsubishi Chemical Corp.

Illustrative examples of the guanidine type curing accelerator include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the metal type curing accelerator include organometallic complexes or organometallic salts of metals such as cobalt, copper, zinc, iron, nickel, manganese, and tin. Specific examples of the organometallic complex include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organometallic salt include zinc octylate, tin octylate, zinc naphthenate, cobalt naphthenate, tin stearate, and zinc stearate.

When the (B) component includes (B-2) the curing accelerator, from a viewpoint to obtain the cured product having further enhanced mechanical characteristics, the content of (B-2) the curing accelerator is, relative to 100% by mass of the non-volatile components in the resin composition, preferably 0.5% or more by mass, and more preferably 1% or more by mass, while still more preferably 1.5% or more by mass, and preferably 5% or less by mass, and more preferably 4% or less by mass, while still more preferably 3% or less by mass.

### -- (B-3) Dispersant --

The (B) component may include (B-3) the dispersant. Illustrative examples of (B-3) the dispersant include: phosphate ester type dispersants such as a polyoxyethylene alkyl ether phosphate; anion type dispersants such as sodium dodecylbenzene sulfonate, sodium laurate, and an ammonium polyoxyethylene alkyl ether sulfate; and nonionic dispersants such as an organosiloxane type dispersant, a polyoxyalkylene type dispersant, an acetylene glycol, a polyoxyethylene alkyl ether, a polyoxyethylene alkyl ester, a polyoxyethylene sorbitan fatty acid ester, a polyoxyethylene alkyl phenyl ether, a polyoxyethylene alkylamine, and a polyoxyethylene alkylamide. Among these, the nonionic dispersants are preferable. (B-3) The dispersant may be used singly, or as a mixture of two or more of those mentioned above.

As for the phosphate ester type dispersant, a commercially available dispersant may be used. Illustrative examples of the commercially available phosphate ester type dispersant include "RS-410", "RS-610", and "RS-710" of the "Phosphanol" series manufactured by Toho Chemical Industry Co., Ltd.

As for the organosiloxane type dispersant, illustrative examples of this type that is commercially available include "BYK 347" and "BYK 348" manufactured by BYK Chemie GmbH.

As for the polyoxyalkylene type dispersant, illustrative examples of this type that is commercially available include "AKM-0531", "AFB-1521", "SC-0505K", "SC-1015F", "SC-0708A", and "HKM-50A" of the "Malialim" series manufactured by NOF Corp. The polyoxyalkylene type dispersant is the general term of the polyoxyethylene alkyl ether, the polyoxyethylene alkyl ester, the polyoxyethylene sorbitan fatty acid ester, the polyoxyethylene alkyl phenyl ether, the polyoxyethylene alkylamine, the polyoxyethylene alkylamide, and the like.

As for the acetylene glycol, illustrative examples of this type that is commercially available include "82", "104", "440", "465", "485", and "Olefin Y" of the "Surfynol" series manufactured by Air Products and Chemicals Inc.

When the (B) component includes (B-3) the dispersant, from a viewpoint to clearly express the advantageous effects of the present invention, the content of (B-3) the dispersant is, on the basis of 100% by mass as the non-volatile components in the resin composition, preferably 0.1% or more by mass, and more preferably 0.3% or more by mass, while still more preferably 0.5% or more by mass. The upper limit thereof is preferably 5% or less by mass, and more preferably 3% or less by mass, while still more preferably 1% or less by mass.

From a viewpoint to clearly express the effects of the present invention, the total content of the (B) component is preferably 1% or more by mass, and more preferably 5% or more by mass, while still more preferably 10% or more by mass, relative to 100% by mass of the non-volatile components in the resin composition. Although the upper limit thereof is not particularly restricted so far as the effects of the present invention can be expressed, this is preferably 30% or less by mass, and more preferably 25% or less by mass, while still more preferably 20% or less by mass.

The (B) component may include a resin component other than the (B-1) component, the (B-2) component, and the (B-3) component. Illustrative examples of the resin component like this include: resin additives such as thermoplastic resins including a phenoxy resin, as well as a flame retardant, a thickener, an antifoaming agent, a leveling material, an adhesion assisting agent, and a colorant.

### <(C) Arbitrary Additive>

The resin composition of the present invention may further include an arbitrary additive as necessary. Illustrative examples of the other additive like this include organometallic compounds such as an organic copper compound, an organic zinc compound, and an organic cobalt compound.

Usually, the resin composition can be in a paste-like form, which is the characteristic that the resin composition has a low viscosity even without including a solvent. Therefore, the content of the solvent in the resin composition is preferably 1.0% or less by mass, more preferably 0.8% or less by mass, and still more preferably 0.5% or less by mass, while especially preferably 0.1% or less by mass, relative to the total mass of the resin composition. Although the lower limit thereof is not particularly restricted, the lower limit is preferably 0.001% or more by mass, or preferably the solvent is not included therein. When a liquid thermosetting resin or the like is used, usually, the viscosity of the resin composition can be lowered even when the solvent is not included therein. When the amount of the solvent in the resin composition is small, not only generation of a void due to evaporation of the solvent can be suppressed, but also a handling property and workability thereof can be made excellent.

### <Production Method of the Resin Composition>

The resin composition may be produced, for example, with a method in which blended components are agitated by using an agitator such as three rollers and a rotation mixer.

### <Physical Property and the Like of the Resin Composition>

Because the resin composition includes the (A-1) component and the (A-2) component as a mixture of them, the cured product of the resin composition has a characteristic of a high relative permeability. Accordingly, the cured product of the resin composition can give the magnetic layer having a high relative permeability. The relative permeability of this cured product at the frequency of 50 MHz is preferably 5 or more, and more preferably 6 or more, while still more preferably 7 or more. Although the upper limit thereof is not particularly restricted, this can be made to 20 or less and the like. The relative permeability may be measured by the method described in Examples to be described later.

Because the resin composition includes the (A-1) component and the (A-2) component as a combination of them, the cured product of the resin composition has a characteristic of a low magnetic loss. Accordingly, the cured product of the resin composition can give the magnetic layer with a low magnetic loss. The magnetic loss of this cured product at the frequency of 50 MHz is preferably 0.15 or less, and more preferably 0.1 or less, while still more preferably 0.08 or less. Although the lower limit thereof is not particularly restricted, this can be made to 0.001 or more and the like. The magnetic loss may be measured by the method described in Examples to be described later.

Usually, the resin composition has a characteristic of low viscosity. Therefore, the resin composition is provided with a paste-like character (resin composition in the paste-like from); so, this can be suitably used as the resin composition to fill a through hole. In addition, the resin composition can be suitably used as the resin composition for production of an inductor element.

### Magnetic Sheet

The magnetic sheet includes a support and a resin composition layer formed on the support, the resin composition layer being formed of the resin composition of the present invention.

In view of thinning, thickness of the resin composition layer is preferably 250 µm or less, and more preferably 200 µm or less. Although the lower limit of the thickness of the resin composition layer is not particularly restricted, it can be usually 5 µm or more, 10 µm or more, or the like.

Illustrative examples of the support include a film formed of a plastic material, metal foil, and a releasing paper. Among them, a film formed of a plastic material and metal foil are preferable.

When the film formed of a plastic material is used as the support, illustrative examples of the plastic material include polyesters such as polyethylene terephthalate (hereinafter, sometimes this is simply called "PET") and polyethylene naphthalate (hereinafter, sometimes this is simply called "PEN"); polycarbonate (hereinafter, sometimes this is simply called "PC"); acrylic polymers such as polymethyl methacrylate (PMMA); a cyclic polyolefin; triacetyl cellulose (TAC); polyether sulfide (PES); polyether ketone; and polyimide. Among them, polyethylene terephthalate and polyethylene naphthalate are preferable, while cheap polyethylene terephthalate is especially preferable.

When the metal foil is used as the support, illustrative examples of the metal foil include copper foil and aluminum foil, while copper foil is preferable. As to the copper foil, the foil formed of a copper single metal or an alloy of copper with other metal (for example, tin, chromium, silver, magnesium, nickel, zirconium, silicon, and titanium) may be used.

The support may be subjected to a treatment such as a mat treatment, or a corona treatment on the surface to be bonded with the resin composition layer.

As for the support, a releasing layer-attached support having a releasing layer on the surface to be bonded to the resin composition layer may be used. The releasing agent used in the releasing layer of the releasing layer-attached support may be one or more releasing agents selected from the group consisting of, for example, an alkyd resin, a polyolefin resin, a urethane resin, and a silicone resin. Commercially available products may be used as the releasing layer-attached support, such as for example, a PET film having a releasing layer formed of the alkyd resin type releasing agent as a main ingredient. Illustrative examples thereof include "PET501010", "SK-1", "AL-5", and "AL-7" all being manufactured by Lintech Corp.; "Lumirror T60" manufactured by Toray Industries; "Purex" manufactured by Teijin Ltd.; and "Unipeel" manufactured by Unitika Ltd.

Although thickness of the support is not particularly restricted, this is preferably in the range of 5 to 75 µm, while more preferably in the range of 10 to 60 µm. When the releasing layer-attached support is used, total thickness of the releasing layer-attached support is preferably within this range.

In the magnet sheet, a protection film similar to the support may be further laminated on the surface of the resin composition layer not bonded to the support (namely, on the surface opposite to the support). Although thickness of the protection film is not particularly restricted, for example, this is in the range of 1 to 40 µm. By laminating the protection film, the surface of the resin composition layer may be prevented from attachment of dirt and the like as well as from a scar. The magnetic sheet can be rolled up so as to be stored. When the magnetic sheet has the protection film, the magnetic sheet can be used by removing the protection film.

The magnetic sheet may be produced by forming a resin composition layer on the support, for example, by applying the resin composition on the support by means of a die coater or the like. As needed, the resin composition is dissolved into an organic solvent to prepare a resin varnish; and then, this resin varnish may be applied onto the support. When an organic solvent is used, drying may be carried out after the application, as needed.

Drying may be carried out by heating, blowing with a hot air, or the like. The drying condition is not particularly restricted. The drying is carried out under the drying condition so as to bring the content of the organic solvent in the resin composition layer to usually 10% or less by mass, while preferably 5% or less by mass. The resin composition layer may be formed by drying in the temperature range of 50 to 150°C for 3 to 10 minutes, although the condition is different depending on the components included in the resin composition.

The magnetic sheet can be rolled up so as to be stored. When the magnetic sheet has the protection film, the magnetic sheet can be used by removing the protection film.

### Circuit Substrate and Production Method thereof

The circuit substrate according to a first embodiment includes a substrate having a through hole and a cured product of the resin composition of the present invention that is filled in the through hole. The circuit substrate according to a second embodiment includes a magnetic layer of the magnetic sheet formed of a cured product of the resin composition layer. Hereinafter, the first embodiment and the second embodiment with regard to the production method of the circuit substrate will be explained. Note that the production method of the circuit substrate relating to the present invention is not limited to the first embodiment or the second embodiment exemplified below.

### <First Embodiment>

The circuit substrate according to the first embodiment is produced, for example, by the production method including following processes (1) to (5). In the first embodiment, it is preferable to form the magnetic layer by using the resin composition, while it is more preferable to form the magnetic layer by using the resin composition in a paste-like form.
(1) A process at which the resin composition is filled in a through hole of the substrate having the through hole;
(2) a process at which the resin composition is thermally cured to obtain a cured product;
(3) a process at which a surface of the cured product or of the resin composition is polished;
(4) a process at which the cured product is subjected to a roughening treatment; and
(5) a process at which a conductive layer is formed on a roughened surface of the cured product.

The production method of the circuit substrate according to the present invention may be carried out in the order of the processes (1) to (5), or the process (2) may be carried out after the process (3).

### <Process (1)>

Upon carrying out the process (1), the process may include a preparation process of the resin composition. The resin composition has already been explained above.

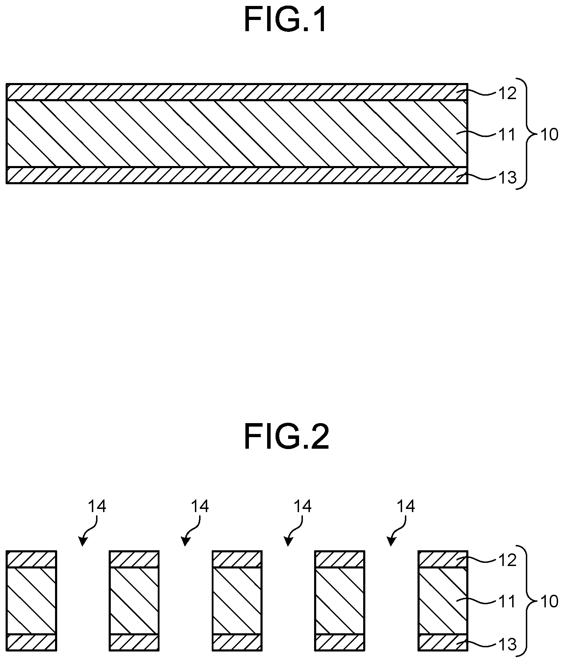

Upon carrying out the process (1), as illustrated in Fig. 1 as one example, the process may include a process to prepare a core substrate 10 having a support substrate 11, and a first metal layer 12 and a second metal layer 13 that are formed of a metal such as copper foil on both surfaces of the support substrate 11. Illustrative examples of the material of the support substrate 11 include an insulating substrate such as a glass epoxy substrate, a metal substrate, a polyester substrate, a polyimide substrate, a BT resin substrate, and a thermosetting type polyphenylene ether substrate. Illustrative examples of the material of the first and the second metal layers include carrier-attached copper foil and a material of the conductive layer to be described later.

In addition, as illustrated in Fig. 2 as one example, the process may include a process to form a through hole 14 in the core substrate 10. The through hole 14 may be formed, for example, by a drill, a laser irradiation, or a plasma irradiation. Specifically, the through hole 14 may be formed by forming a penetrating hole in the core substrate 10 by using a drill or the like.

Formation of the through hole 14 may be carried out by using a drilling machine that is commercially available. Illustrative examples of the commercially available drilling machine include "ND-1S211" manufactured by Hitachi Via Mechanics, Ltd.

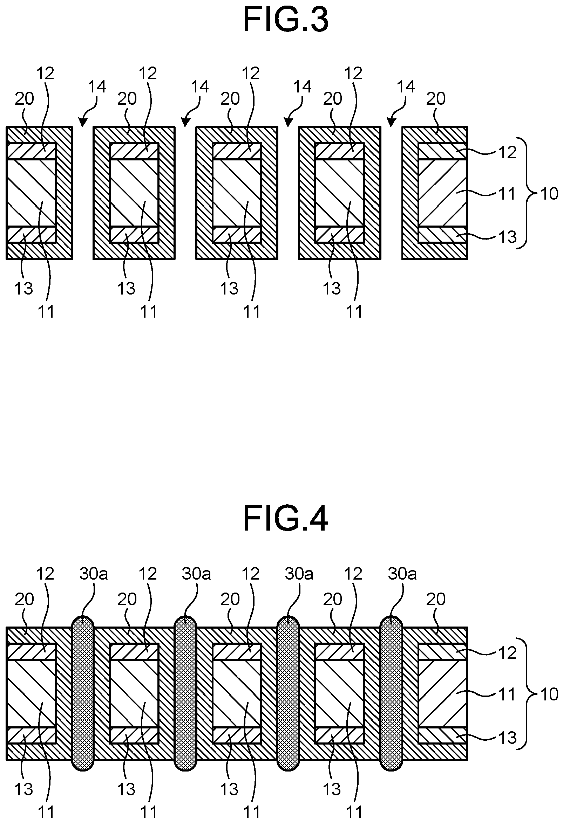

After the through hole 14 is formed in the core substrate 10, as illustrated in Fig. 3 as one example, the process may include a process to carry out a roughening treatment to the core substrate 10 followed by formation of a plated layer 20 in the through hole 14, on the surface of the first metal layer 12, and on the surface of the second metal layer 13.

The roughening treatment may be carried out with any of a dry roughening treatment and a wet roughening treatment. Illustrative examples of the dry roughening treatment include a plasma treatment. Illustrative examples of the wet roughening treatment include a method in which a swelling treatment by a swelling liquid, a roughening treatment by an oxidant, and a neutralizing treatment by a neutralizing solution are carried out in this order.

The plated layer 20 is formed by a plating method. The procedure to form the plated layer 20 by the plating method is the same as that in formation of a conductive layer at the process (5) to be described later.

After the core substrate 10 is prepared, as illustrated in Fig. 4 as one example, a resin composition 30a is filled into the through hole 14. The filling may be carried out, for example, by a printing method. Illustrative examples of the printing method include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

### <Process (2)>

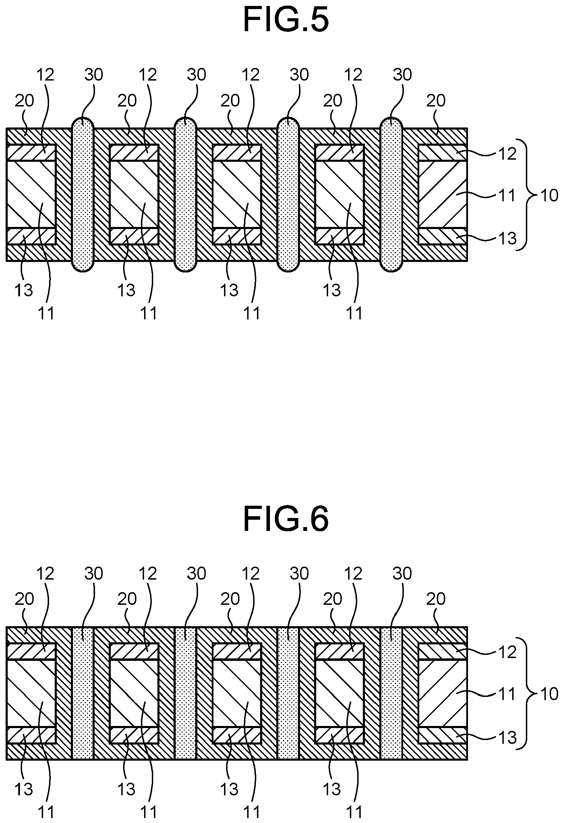

After the resin composition 30a is filled into the through hole 14, at the process (2), the resin composition 30a is thermally cured to form a cured product layer (magnetic layer) 30 in the through hole 14, as illustrated in Fig. 5 as one example. The thermal curing condition of the resin composition 30a is different depending on the composition and kind of the resin composition 30a. The curing temperature is preferably 120°C or higher, and more preferably 130°C or higher, while still more preferably 150°C or higher, and preferably 245°C or lower, and more preferably 220°C or lower, while still more preferably 200°C or lower. The curing time of the resin composition 30a is preferably 5 minutes or longer, and more preferably 10 minutes or longer, while still more preferably 15 minutes or longer, and preferably 120 minutes or shorter, and more preferably 100 minutes or shorter, while still more preferably 90 minutes or shorter.

The curing degree of the magnetic layer 30 at the process (2) is preferably 80% or more, and more preferably 85% or more, while still more preferably 90% or more. The curing degree may be measured, for example, by using a differential scanning calorimeter.

Before the resin composition 30a is thermally cured, the resin composition 30a may be subjected to a preliminary heat treatment by heating at the temperature lower than the curing temperature. For example, prior to the thermal curing of the resin composition 30a, the resin composition 30a may be preliminary heated usually in the temperature range of 50°C or higher to lower than 120°C (preferably in the range of 60°C or higher and 110°C or lower, while more preferably in the range of 70°C or higher and 100°C or lower), and for the period of usually 5 minutes or longer (preferably in the range of 5 to 150 minutes, while more preferably in the range of 15 to 120 minutes).

When the process (3) is carried out after the process (2), among other purposes, with a purpose to further increase the curing degree of the magnetic layer, a heat treatment may be carried out, as needed, after the process (2) and before the process (3). The temperature at the heating process may be similar to the curing temperature described before. Therefore, the temperature is preferably 120°C or higher, and more preferably 130°C or higher, while still more preferably 150°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

When the process (3) is carried out before the process (2), a preliminary heat treatment may be carried out before the process (3) by heating at the temperature lower than the curing temperature of the resin composition. The temperature at the preliminary heat treatment is preferably 100°C or higher, and more preferably 110°C or higher, while still more preferably 120°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

### <Process (3)>

At the process (3), as illustrated in Fig. 6 as one example, an excess amount of the magnetic layer 30 that is projected from or attached to the core substrate 10 is removed by polishing to flatten the surface thereof. The polishing method that can polish the excess amount of the magnetic layer 30 that is projected from or attached to the core substrate 10 may be used. Illustrative examples of the polishing method like this include a buff polishing method and a belt polishing method. Illustrative examples of the buff polishing equipment that is commercially available include "NT-700IM" manufactured by Ishii Hyoki Co., Ltd.

From a viewpoint to enhance the adhesion with a plating, the arithmetic average roughness (Ra) of the polished surface of the magnetic layer (magnetic layer after thermal curing) is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

When the process (3) is carried out after the process (2), among other purposes, with a purpose to further increase the curing degree of the magnetic layer, a heat treatment may be carried out, as needed, after the process (2) and before the process (3). The temperature at the heating process may be similar to the curing temperature described before. Therefore, the temperature is preferably 120°C or higher, and more preferably 130°C or higher, while still more preferably 150°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

When the process (3) is carried out before the process (2), a preliminary heat treatment may be carried out before the process (3) by heating at the temperature lower than the curing temperature of the resin composition. The temperature at the preliminary heat treatment is preferably 100°C or higher, and more preferably 110°C or higher, while still more preferably 120°C or higher, and preferably 245°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

### <Process (4)>

At the process (4), the surface having been polished at the process (3) is subjected to a roughening treatment (desmearing treatment). The procedure and the condition of the roughening process are not particularly restricted. Heretofore known procedure and condition that are usually used in the production method of a multilayer printed wiring board may be used. At the roughening process, a first magnetic layer 32 may be roughened, for example, by carrying out a swelling treatment with a swelling liquid, a roughening treatment with an oxidant, and a neutralization treatment with a neutralizing solution in this order.

The swelling liquid to be used in the roughening process is not particularly restricted. Illustrative examples thereof include an alkaline solution and a surfactant solution, and the alkaline solution is preferable. As for the alkaline solution as the swelling liquid, a sodium hydroxide solution and a potassium hydroxide solution are more preferable. Illustrative examples of the swelling liquid that is commercially available include "Swelling Dip Securiganth P" and "Swelling Dip Securiganth SBU" (both are manufactured by Atotech Japan Co., Ltd.).

The swelling treatment with the swelling liquid is not particularly restricted. For example, this can be carried out by soaking the core substrate 20 formed with the first magnetic layer 32 into the swelling liquid in the temperature range of 30°C to 90°C and for the period of 1 to 20 minutes. From a viewpoint to suppress the swelling of the resin that constitutes the first magnetic layer 32 to a suitable level, it is preferable to soak the first magnetic layer 32 into the swelling liquid in the temperature range of 40°C to 80°C and for the period of 5 to 15 minutes.

The oxidant to be used in the roughening treatment by the oxidant is not particularly restricted. Illustrative examples thereof include an alkaline permanganate solution having potassium permanganate or sodium permanganate dissolved into a sodium hydroxide aqueous solution. The roughening treatment by the oxidant such as the alkaline permanganate solution or the like may be carried out preferably by soaking the first magnetic layer 32 into the oxidant solution heated at 60°C to 80°C for the period of 10 to 30 minutes. The concentration of the permanganate salt in the alkaline permanganate solution is preferably in the range of 5 to 10% by mass. Illustrative examples of the oxidant that is commercially available include alkaline permanganate solutions such as "Concentrate Compact P" and "Dosing Solution Securiganth P" (both are manufactured by Atotech Japan, Co., Ltd.).

The neutralization solution to be used in the neutralization treatment is preferably an acidic aqueous solution. Illustrative examples of the commercially available product thereof include "Reduction Solution Securiganth P" (manufactured by Atotech Japan Co., Ltd.). The neutralization treatment with the neutralization solution can be carried out by soaking the surface treated with the roughening treatment using the oxidant solution into the neutralization solution in the temperature range of 30°C to 80°C for the period of 5 to 30 minutes. In view of workability and so forth, it is preferable to soak the first magnetic layer 32, which have been treated with the roughening treatment by using the oxidant solution, into the neutralization solution in the temperature range of 40°C to 70°C for the period of 5 to 20 minutes.

From a viewpoint to enhance the adhesion with a plating, the arithmetic average roughness (Ra) of the magnetic layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured, for example, by using a non-contact type surface roughness meter.

### <Process (5)>

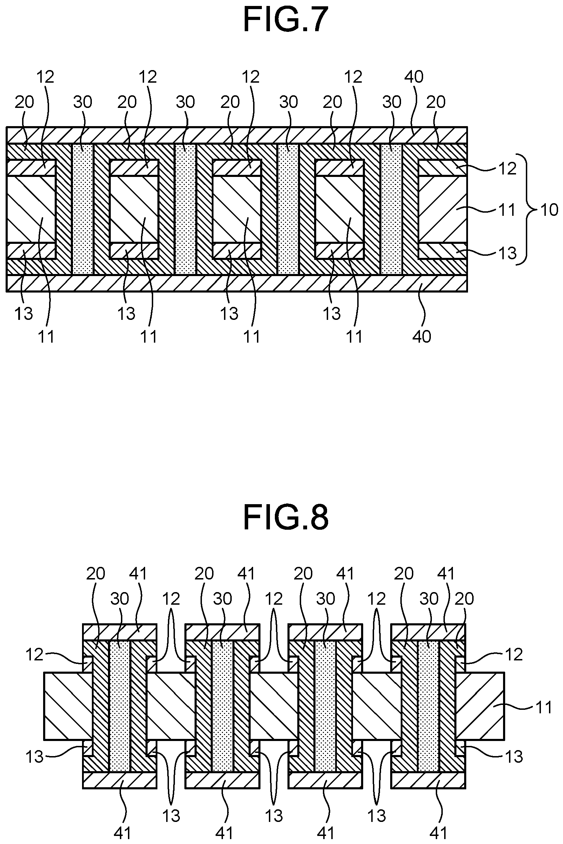

At the process (5), as illustrated in Fig. 7 as one example, a conductive layer 40 is formed on the polished surface of the magnetic layer 30 and on the core substrate. Then, after the conductive layer 40 is formed, as illustrated in Fig. 8 as one example, by carrying out a treatment such as etching, a patterned conductive layer 41 may be formed by removing part of the conductive layer 40, the first metal layer 12, the second metal layer 13, and the plated layer 20. In Fig. 7, the conductive layer 40 is formed on both surfaces of the core substrate 10, but the conductive layer 40 may be formed on only one surface of the core substrate 10.

Illustrative examples of the method for forming the conductive layer include a plating method, a sputtering method, and a vacuum evaporation method. Among them, the plating method is preferable. In the preferable embodiment, the surface of the cured product is plated with an appropriate method such as a semi-additive method or a full additive method to form the patterned conductive layer having an intended wiring pattern. Illustrative examples of the material of the conductive layer include: a single metal such as gold, platinum, palladium, silver, copper, aluminum, cobalt, chromium, zinc, nickel, titanium, tungsten, iron, tin, and indium; and metal alloys of two or more metals selected from the group consisting of gold, platinum, palladium, silver, copper, aluminum, cobalt, chromium, zinc, nickel, titanium, tungsten, iron, tin, and indium. Among these, from viewpoints of general applicability, cost, easiness in patterning, and the like, preferable to be used are chromium, nickel, titanium, aluminum, zinc, gold, palladium, silver, and copper, as well as a nickel-chromium alloy, a copper-nickel alloy, and a copper-titanium alloy. More preferable to be used are chromium, nickel, titanium, aluminum, zinc, gold, palladium, silver, and copper, as well as a nickel-chromium alloy. Copper is still more preferable.

Here, an example of the embodiment to form the patterned conductive layer on the polished surface of the cured product will be explained in detail. A plated seed layer is formed on the polished surface of the cured product by electroless plating. Next, onto the plated seed layer thus formed, an electroplated layer is formed by electroplating; and as needed, an unnecessary plated seed layer is removed by a treatment such as etching, whereby the conductive layer having an intended wiring pattern can be formed. After the conductive layer is formed, among other purposes, with a purpose to enhance the peel strength of the conductive layer, an annealing treatment may be carried out, as necessary. The annealing treatment may be carried out, for example, by heating the circuit substrate in the temperature range of 150 to 200_{°}C for the period of 20 to 90 minutes.

From a viewpoint of thinning, the thickness of the patterned conductive layer is preferably 70 um or less, more preferably 60 um or less, still more preferably 50 um or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

### Second Embodiment

The circuit substrate according to the second embodiment includes a magnetic layer formed of a cured product of the resin composition. In the second embodiment, it is preferable to form the magnetic layer by using a magnetic sheet. Hereinafter, the second embodiment with regard to the production method of a product substrate will be explained. Explanation overlapped with the first embodiment will be omitted as appropriate.

The circuit substrate of the second embodiment is produced, for example, by the production method including the following processes (A) to (D):
(A) a process at which a magnetic sheet is laminated to an inner substrate such that a resin composition layer be bonded to the inner substrate to form a magnetic layer;
(B) a process at which a hole-making process to form a hole in the magnetic layer is carried out;
(C) a process at which a surface of the magnetic layer is subjected to a roughening treatment: and
(D) a process at which a conductive layer is formed on a polished surface of the magnetic layer.

Hereinafter, upon producing the circuit substrate, the processes (A) to (D) will be explained in detail.

### <Process (A)>

The process (A) is the process at which a magnetic sheet is laminated to an inner substrate such that a resin composition layer may be bonded to the inner substrate to form a magnetic layer. In one embodiment of the process (A), the magnetic sheet is laminated to the inner substrate such that the resin composition layer may be bonded to the inner substrate, and then, the resin composition layer is thermally cured to form the magnetic layer.

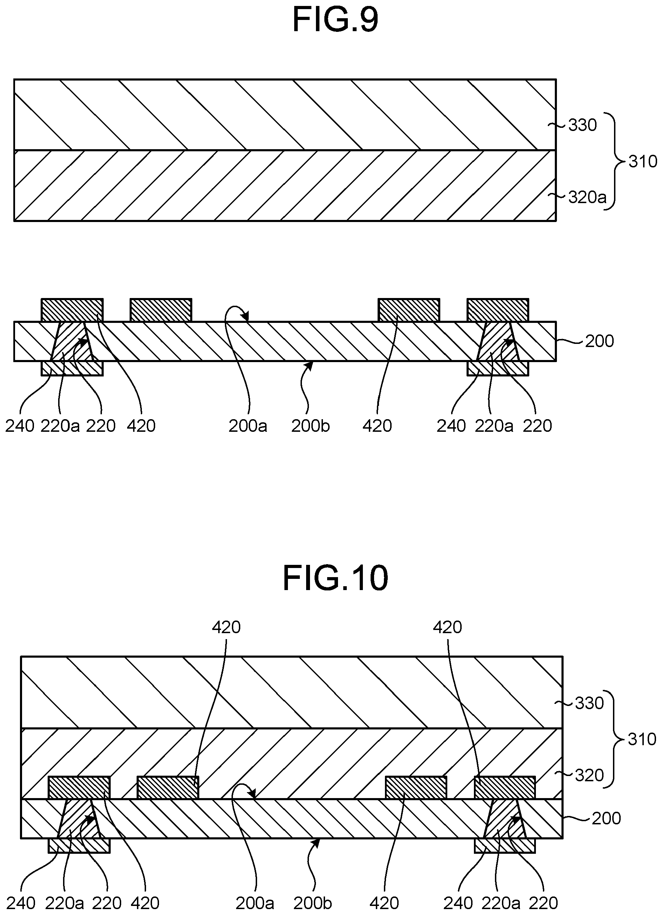

At the process (A), as illustrated in Fig. 9 as one example, a magnetic sheet 310 having a support 330 and a resin composition layer 320a formed on the support 330 is laminated to an inner substrate 200 such that the resin composition layer 320a may be bonded to the inner substrate 200.

The inner substrate 200 is an insulating substrate. Illustrative examples of the material of the inner substrate 200 include insulating substrates such as a glass epoxy substrate, a metal substrate, a polyester substrate, a polyimide substrate, a BT resin substrate, and a thermosetting type polyphenylene ether substrate. The inner substrate 200 may be an inner layer circuit substrate having a wiring or the like incorporated in the thickness thereof.

As illustrated in Fig. 9 as one example, the inner substrate 200 has a first conductive layer 420 formed on a first main surface 200a and an outside terminal 240 formed on a second main surface 200b. The first conductive layer 420 may include a plurality of wirings. In the example illustrated by the drawing, only a wiring that constitutes a coil-like conductive structural body 400 of an inductor element is illustrated. The outside terminal 240 is a terminal to electrically connect to an outside device or the like that is not illustrated in the drawing. The outside terminal 240 may be constructed as part of a conductive layer formed on the second main surface 200b.

Conductive materials that are capable of constructing the first conductive layer 420 and the outside terminal 240 are the same as the materials of the conductive layer that have been explained in the paragraphs of "Process (5)" of the first embodiment.

The first conductive layer 420 and the outside terminal 240 may be any of a monolayer structure and a multilayer structure in which two or more layers formed of single metal layers formed of different metals or of alloy layers are laminated. Thicknesses of the first conductive layer 420 and of the outside terminal 240 are the same as those of a second conductive layer 440 to be described later.

The line (L)/space (S) ratios of the first conductive layer 420 and of the outside terminal 240 are not particularly restricted. From a viewpoint to reduce irregularity of the surface thereby obtaining the magnetic layer that is excellent in the smoothness, the ratio is usually 900/900 µm or less, preferably 700/700 um or less, more preferably 500/500 µm or less, and still more preferably 300/300 um or less, while far still more preferably 200/200 µm or less. Although the lower limit of the line/space ratio is not particularly restricted, from a viewpoint to enhance an embedding property of the resin composition layer into the space, the ratio is preferably 1/1 um or more.

The inner substrate 200 may have a plurality of through holes 220 such that these may penetrate the inner substrate 200 from the first main surface 200a to the second main surface 200b. In the through hole 220, an inside-the-through-hole wiring 220a is formed. The inside-the-through-hole wiring 220a electrically connects the first conductive layer 420 with the outside terminal 240.

Bonding of the resin composition layer 320a to the inner layer substrate 200 may be carried out, for example, by hot-press bonding of the magnetic sheet 310 to the inner layer substrate 200 from the side of the support 330. Illustrative examples of the component for hot-press bonding of the magnetic sheet 310 to the inner layer substrate 200 (hereinafter, this component is also called "hot-pressing component") include a heated metal plate (stainless steel (SUS) mirror plate or the like) and a heated metal roll (SUS roll). At this time, it is preferable that the hot-pressing component be not pressed directly to the magnetic sheet 310 but pressed via a sheet or the like formed of an elastic material such as a heat-resistant rubber so that the magnetic sheet 310 may well follow the surface irregularity of the inner layer substrate 200.

The temperature at the time of the hot-press bonding is preferably in the range of 80°C to 160°C, and more preferably in the range of 90°C to 140°C, while still more preferably in the range of 100°C to 120°C. The pressure at the time of the hot-press bonding is preferably in the range of 0.098 to 1.77 MPa, while more preferably in the range of 0.29 to 1.47 MPa. The period at the time of the hot-press bonding is preferably in the range of 20 to 400 seconds, while more preferably in the range of 30 to 300 seconds. The bonding of the magnetic sheet to the inner substrate is carried out preferably under an evacuated condition with the pressure of 26.7 hPa or less.

Bonding of the resin composition layer 320a of the magnetic sheet 310 to the inner layer substrate 200 may be carried out by using a commercially available vacuum laminator. Illustrative examples of the commercially available vacuum laminator include a vacuum and pressure laminator manufactured by Meiki Co., Ltd. and a vacuum applicator manufactured by Nikko-Materials Co., Ltd.

After bonding of the resin sheet 310 to the inner layer substrate 200, under a normal pressure (under an atmospheric pressure), for example, the laminated magnetic sheet 310 may be flattened by pressing the hot-pressing component from the side of the support thereof. The pressing conditions of the flattening process can be the same as the hot-press bonding conditions in the beforementioned lamination. The flattening process may be carried out by using a commercially available laminator. Note that the lamination and the flattening processes may be carried out continuously by using the commercially available vacuum laminator described above.

After the magnetic sheet is laminated to the inner substrate, the resin composition layer is thermally cured to form a magnetic layer. As illustrated in Fig. 10 as one example, the resin composition layer 320a that is bonded to the inner substrate 200 is thermally cured to form a first magnetic layer 320.

Conditions of the thermal curing of the resin composition layer 320a are different depending on the composition and kind of the resin composition. The curing temperature is preferably 120°C or higher, and more preferably 130°C or higher, while still more preferably 150°C or higher, and preferably 245°C or lower, and more preferably 220°C or lower, while still more preferably 200°C or lower. The curing period of the resin composition layer 320a is preferably 5 minutes or longer, and more preferably 10 minutes or longer, while still more preferably 15 minutes or longer, and preferably 120 minutes or shorter, and more preferably 100 minutes or shorter, while still more preferably 90 minutes or shorter.

The support 330 may be removed between the time after thermal curing at the process (A) and the process (B), or after the process (B).

From a viewpoint to enhance the adhesion with a plating, the arithmetic average roughness (Ra) of the magnetic layer before the roughening treatment is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

At the process (A), the magnetic layer may be formed by applying the resin composition, instead of the magnetic sheet, to the inner layer substrate by using a die coater or the like followed by thermal curing thereof.

### <Process (B)>

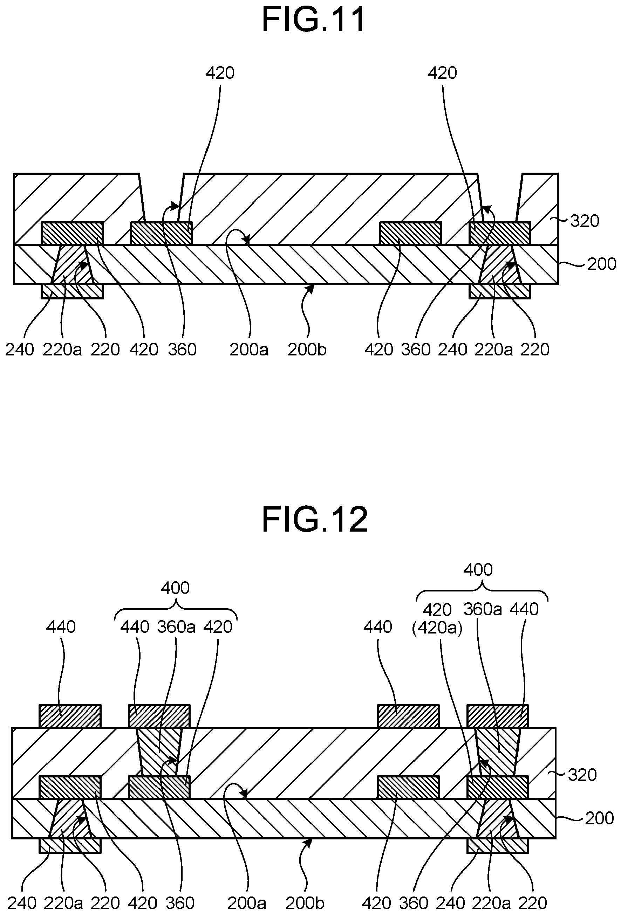

At the process (B), as illustrated in Fig. 11 as one example, a via hole 360 is formed by carrying out the hole-making process in the first magnetic layer 320. The via hole 360 will be a channel to electrically connect the first magnetic layer 420 with the second conductive layer 440 to be described later. Formation of the via hole 360 may be carried out by using a drill, a laser, a plasma, or the like in accordance with composition and the like of the resin composition used to form the magnetic layer. The size and shape of the hole may be arbitrarily determined in accordance with a design of the printed wiring board.

### <Process (C)>

At the process (C), the surface of the magnetic layer formed with the via hole is subjected to a roughening treatment. The roughening treatment at the process (C) is the same as that explained in the paragraphs of "Process (4)" in the first embodiment.

From a viewpoint to enhance the adhesion with a plating, the arithmetic average roughness (Ra) of the magnetic layer after the roughening treatment is preferably 300 nm or more, and more preferably 350 nm or more, while still more preferably 400 nm or more. The upper limit thereof is preferably 1,500 nm or less, and more preferably 1,200 nm or less, while still more preferably 1,000 nm or less. The surface roughness (Ra) may be measured, for example, by a non-contact type surface roughness meter.

At the process (C), by polishing in place of the roughening treatment, an excess amount of the magnetic layer that is projected from or attached to the core substrate 10 may be removed so as to flatten the surface thereof. The polishing method is the same as that explained before.

### <Process (D)>

At the process (D), as illustrated in Fig. 12 as one example, the second conductive layer 440 is formed on the first magnetic layer 320.

The conductive materials that are capable of constituting the second conductive layer 440 are the same as those of the conductive layer explained in the paragraphs of "Process (5)" in the first embodiment.

From a viewpoint of thinning, the thickness of the second conductive layer 440 is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as a full additive method. When the second conductive layer 440 is formed by the wet plating method, the second conductive layer 440 having an intended wiring pattern can be formed. Note that, at this process, an inside-the-via-hole wiring 360a is concurrently formed in the via hole 360.

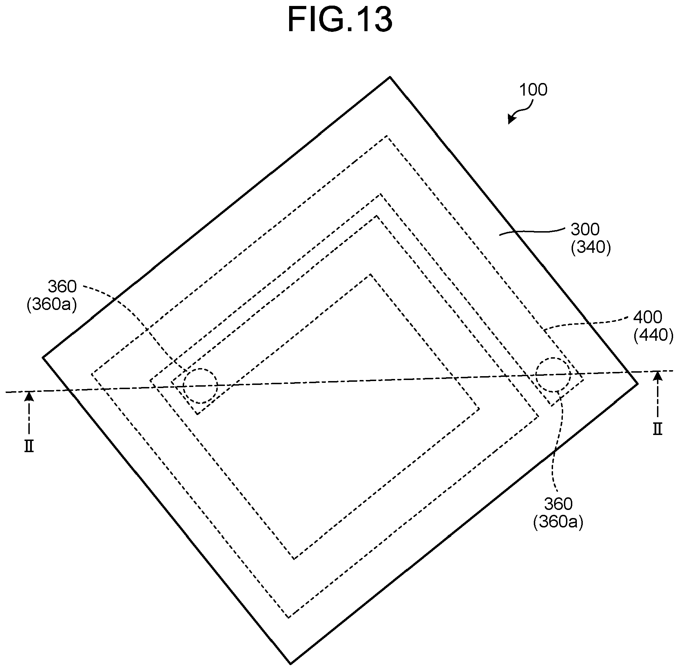

The first conductive layer 420 and the second conductive layer 440 may be formed, for example, spirally, as illustrated in Fig. 13 to Fig. 15 to be described later as one example. In one example, one end in the center side of the spiral wiring of the second conductive layer 440 is electrically connected through the inside-the-via-hole wiring 360a to one end in the center side of the spiral wiring of the first conductive layer 420. Other end in the circumferential side of the spiral wiring of the second conductive layer 440 is electrically connected through the inside-the-via-hole wiring 360a to a land 420a of the first conductive layer 420. Therefore, the other end in the circumferential side of the spiral wiring of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring that is part of the first conductive layer 420, the spiral wiring that is part of the second conductive layer 440, and the inside-the-via-hole wiring 360a that electrically connects between the spiral wiring of the first conductive layer 420 and the spiral wiring of the second conductive layer 440.

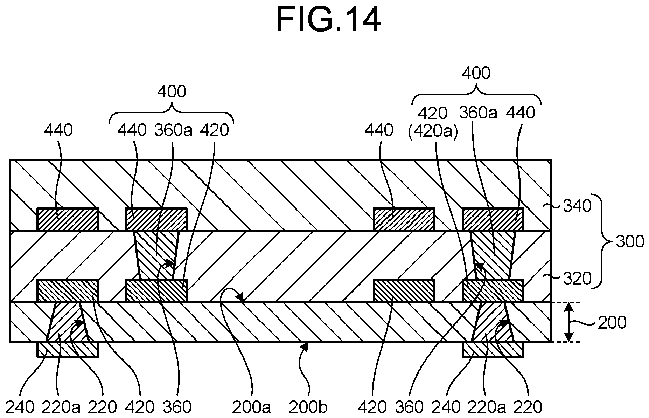

After the process (D), a process to further form a magnetic layer on the conductive layer may be carried out. Specifically, as illustrated in Fig. 14 as one example, a second magnetic layer 340 is formed on the first magnetic layer 320 that has the second conductive layer 440 and the inside-the-via-hole wiring 360a formed therein. The second magnetic layer may be formed with the same process as the process that has already been explained.

### Inductor Substrate

The inductor substrate includes the circuit substrate of the present invention. When the inductor substrate includes the circuit substrate obtained by the production method of the circuit substrate according to the first embodiment, the inductor substrate has an inductor pattern that is formed by a conductor at least in part around the cured product of the resin composition. The inductor substrate like this may be, for example, the one that is described in Japanese Patent Application Laid-open No. 2016-197624.

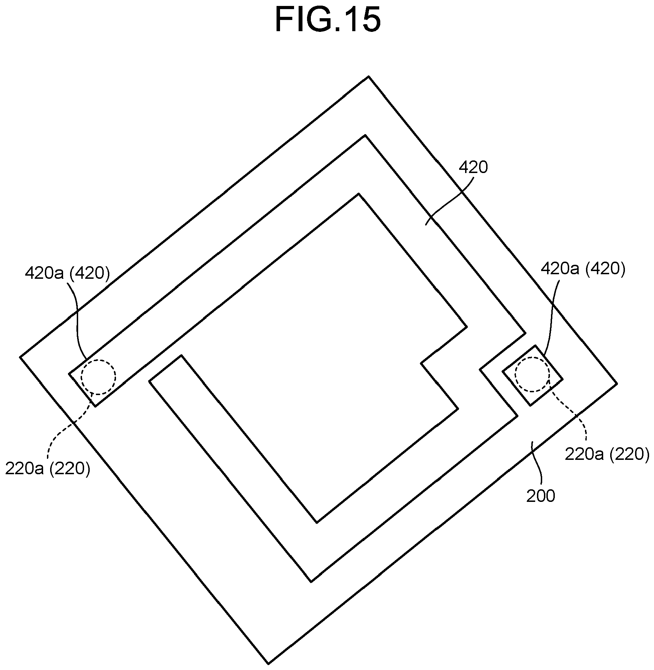

When the inductor substrate includes the circuit substrate obtained by the production method of the circuit substrate according to the second embodiment, the inductor substrate has a magnetic layer and a conductive structural body having at least part thereof been embedded into the magnetic layer. The inductor substrate includes this conductive structural body and an inductor element that is extendedly present in a thickness direction of the magnetic layer and is composed of part of the magnetic layer surrounded with the conductive structural body. Note that, Fig. 13 is a schematic plane view from one direction in a thickness direction of the inductor substrate, which includes the inductor element therein. Fig. 14 is a schematic plane view illustrating a cut end face of the inductor substrate that is cut at the place indicated by the II-II one dot chain line illustrated in Fig. 13. Fig. 15 is a schematic plane view to explain a composition of the first conductive layer in the inductor substrate.

As illustrated in Fig. 13 and Fig. 14 as one example, a circuit substrate 100 has a plurality of the magnetic layers (the first magnetic layer 320 and the second magnetic layer 340) and a plurality of the conductive layers (the first conductive layer 420 and the second conductive layer 440). Namely, this is a build-up wiring board having a build-up magnetic layer and a build-up conductive layer. Also, the circuit substrate 100 has an inner substrate 200.

From Fig. 14, the first magnetic layer 320 and the second magnetic layer 340 constitute a magnetic member 300, which can be regarded as an integrated magnetic layer of these magnetic layers. Therefore, the coil-like conductive structural body 400 is formed such that at least part thereof may be embedded into the magnetic member 300. Namely, in the circuit substrate 100 according to this embodiment, the inductor element is composed of the coil-like conductive structural body 400 and a core part, which is extendedly present in the thickness direction of the magnetic member 300 and is part of the magnetic member 300 that is surrounded with the coil-like conductive structural body 400.

As illustrated in Fig. 15 as one example, the first conductive layer 420 includes the spiral wiring to constitute the coil-like conductive structure 400 and the land 420a in a square shape that is electrically connected to the inside-the-through-hole wiring 220a. In the example illustrated by the drawing, the spiral wiring includes a linear portion, a bent portion that is bent at a right angle to the linear portion, and a detour portion that detours the land 420a. In the example illustrated by the drawing, outline of the entire spiral wiring of the first conductive layer 420 is substantially in a square shape and has a shape that the wiring is whirled in the anticlockwise direction from a center side to an outer side.

Similarly, the second conductive layer 440 is formed on the first magnetic layer 320. The second conductive layer 440 includes the spiral wiring to constitute the coil-like conductive structural body 400. In Fig. 13 or Fig. 14, the spiral wiring includes a linear portion and a bent portion that is bent at a right angle to the linear portion. In Fig. 13 or Fig. 14, outline of the entire spiral wiring of the second conductive layer 440 is substantially in a square shape and has a shape that the wiring is whirled clockwise from a center side to an outer side.

The inductor substrate can be used as the wiring board to mount an electronic part such as a semiconductor chip, and can also be used as a (multilayered) printed wiring board that uses this wiring board as the inner substrate. In addition, this can be used as a chip inductor part obtained by dicing the wiring board, and can also be used as a printed wiring board that is surface-mounted with the chip inductor part.

In addition, by using this wiring board, semiconductor devices with various embodiments may be produced. The semiconductor device having the wiring board can be suitably used in electric products (for example, a computer, a mobile phone, a digital camera, and a television), vehicles (for example, a motor bike, an automobile, a train, a marine ship, and an airplane), and so forth.

### EXAMPLES

Hereinafter, the present invention will be specifically explained, but the present invention is not limited to these Examples. Note that, in the description below, "part" and "%" that describe quantity mean "part by mass" and "% by mass", respectively, unless otherwise specifically mentioned.

### <Measurement of Compact Powder Resistance of Magnetic Powder>

The compact powder resistance of the magnetic powder was measured by using a resistivity measurement instrument (MCP-PD51 Type; powder resistance measurement system manufactured by Mitsubishi Chemical Analytech Co., Ltd.). Specifically, after 5 g of the magnetic powder was filled in a cylindrical measurement container having an inner diameter of 20 mm to form a magnetic powder layer, a load of 4 kN was applied onto this magnetic powder layer thereby pressing to obtain a compressed powder body. The thickness and resistance of this compressed powder body were measured at 25°C and humidity of 50% under the compressed state thereof (retaining the load of 4 kN). From these values and the inner diameter of the measurement container, a volume resistivity of the compressed powder body was calculated. This value was obtained as the compact powder resistance.

### Example 1

To 35 parts by mass of magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) and 16 parts by mass of magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) were added 3 parts by mass of liquid epoxy resin a ("ZX-1059" (mixture of bisphenol A type epoxy resin and bisphenol F type epoxy resin) manufactured by Nippon Steel Chemical & Material Co., Ltd.), 3 parts by mass of liquid epoxy resin b ("EP-4088S" (dicyclopentadiene type epoxy resin) manufactured by ADEKA Corp.), 1 part by mass of liquid epoxy resin c ("630" (glycidyl ether type aromatic epoxy resin) manufactured by Mitsubishi Chemical Corp.), and 1 part by mass of curing facilitator a ("2MZA-PW" (imidazole type curing facilitator) manufactured by Shikoku Chemicals Corp.); then, the resulting mixture was uniformly dispersed by means of a high-rotation mixer to obtain resin composition 1.

### Example 2

Example 2 was carried out by the same way as Example 1, except that, in Example 1, the amount of the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was changed from 35 parts by mass to 25.5 parts by mass, and that the amount of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was changed from 16 parts by mass to 25.5 parts by mass, to obtain resin composition 2.

### Example 3

Example 3 was carried out by the same way as Example 1, except that, in Example 1, the amount of the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was changed from 35 parts by mass to 16 parts by mass, and that the amount of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was changed from 16 parts by mass to 35 parts by mass, to obtain resin composition 3.

### Example 4

Example 4 was carried out by the same way as Example 1, except that, in Example 1, the amount of the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was changed from 35 parts by mass to 7 parts by mass, and that the amount of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was changed from 16 parts by mass to 44 parts by mass, to obtain resin composition 4.

### Example 5

Example 5 was carried out by the same way as Example 1, except that, in Example 1, the amount of the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was changed from 35 parts by mass to 25.5 parts by mass, and that 16 parts by mass of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was changed to 35 parts by mass of magnetic powder c ("AW08PF10F": soft magnetic powder (Fe-Si-based alloy) manufactured by Epson Atmix Corp., compact powder resistance with 4 kN: 2.3×10³ Ω·cm, true specific gravity: 7.0 g/cm³), to obtain resin composition 5.

### Example 6

Example 6 was carried out by the same way as Example 1, except that, in Example 1,the amount of the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was changed from 35 parts by mass to 25.5 parts by mass, and that 16 parts by mass of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was changed to 40 parts by mass of magnetic powder d ("Fe-50%NiPF10F": soft magnetic powder (Fe-Ni-based alloy) manufactured by Epson Atmix Corp., compact powder resistance with 4 kN: 1.9×10² Ω·cm, true specific gravity: 8.0 g/cm³), to obtain resin composition 6.

### Comparative Example 1

Comparative Example 1 was carried out by the same way as Example 1, except that, in Example 1, the amount of the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was changed from 35 parts by mass to 51 parts by mass, and that 16 parts by mass of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was not used, to obtain resin composition 7.

### Comparative Example 2

Comparative Example 2 was carried out by the same way as Example 1, except that, in Example 1, the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was not used, and that the amount of the magnetic powder b ("Z05": soft magnetic powder (Mn-Zn-based ferrite) manufactured by Powdertech Co., Ltd., compact powder resistance with 4 kN: 4.5×10³ Ω·cm, true specific gravity: 5.0 g/cm³) was changed from 16 parts by mass to 51 parts by mass, to obtain resin composition 8.

### Comparative Example 3

Comparative Example 3 was carried out by the same way as Example 5, except that, in Example 5, the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was not used, and that the amount of the magnetic powder c ("AW08PF10F": soft magnetic powder (Fe-Si-based alloy) manufactured by Epson Atmix Corp., compact powder resistance with 4 kN: 2.3×10³ Ω·cm, true specific gravity: 7.0 g/cm³) was changed from 35 parts by mass to 70.5 parts by mass, to obtain resin composition 9.

### Comparative Example 4

Comparative Example 4 was carried out by the same way as Example 6, except that, in Example 6, the magnetic powder a ("M05S": soft magnetic powder (Mn-based ferrite) manufactured by Powdertech Co., Ltd., compact powder resistance with 4 kN: 1.5×10⁶ Ω·cm, true specific gravity: 5.0 g/cm³) was not used, and that the amount of the magnetic powder d ("Fe-50%NiPF10F": soft magnetic powder (Fe-Ni-based alloy) manufactured by Epson Atmix Corp., compact powder resistance with 4 kN: 1.9×10² Ω·cm, true specific gravity: 8.0 g/cm³) was changed from 40 parts by mass to 80.5 parts by mass, to obtain resin composition 10.

### <Measurement of Relative Permeability and Magnetic Loss>

A polyethylene terephthalate (PET) film ("PET 501010"; thickness of 50 um; manufactured by Lintec Corp.) that was treated with a silicone type releasing agent was prepared as a support. Each of the resin compositions 1 to 10 was uniformly applied onto the release-treated surface of the PET film by using a doctor blade such that the thickness of the resin composition layer after dried might become 100 um to obtain a magnetic sheet. The magnetic sheet thereby obtained was heated at 180°C for 90 minutes to thermally cure the resin composition layer; and then, the support was removed to obtain a cured product in a sheet form. The cured product thus obtained was cut to a toroidal type specimen having the outer diameter of 19 mm and the inner diameter of 9 mm; this was used as a sample for evaluation. The relative permeability (µ') and the imaginary part (µ") of this evaluation sample were measured by using Keysight Technology ("16454A E4991B"; manufactured by Keysight Technologies, Inc.) at room temperature (23°C) with the measurement frequency of 50 MHz. The magnetic loss was calculated from µ"/µ'.

**Table 1 - part 1**

| | | | Example | | | | | |
|---|---|---|---|---|---|---|---|---|
| | | | 1 | 2 | 3 | 4 | 5 | 6 |
| Resin composition No. | | | 1 | 2 | 3 | 4 | 5 | 6 |
| (A) Component | (A-1) Component | Magnetic powder a | 35 | 25.5 | 16 | 7 | 22.4 | 22.4 |
| | (A-2) Component | Magnetic powder b | 16 | 25.5 | 35 | 44 | | |
| | | Magnetic powder c | | | | | 33.6 | |
| | | Magnetic powder d | | | | | | 33.6 |
| (B) Component | (B-1) Component | Liquid epoxy resin a | 3 | 3 | 3 | 3 | 3 | 3 |
| | | Liquid epoxy resin b | 3 | 3 | 3 | 3 | 3 | 3 |
| | | Liquid epoxy resin c | 1 | 1 | 1 | 1 | 1 | 1 |
| | (B-2) Component | Curing accelerator a | 1 | 1 | 1 | 1 | 1 | 1 |
| a1 (% by volume) | | | 69 | 50 | 31 | 14 | 48 | 52 |
| a2 (% by volume) | | | 31 | 50 | 69 | 86 | 52 | 48 |
| a1/a2 | | | 2.19 | 1.00 | 0.46 | 0.16 | 0.93 | 1.07 |
| Content of (A) component (% by volume) | | | 56 | 56 | 56 | 56 | 54 | 52 |
| Relative permeability (50 MHz) | | | 7.5 | 8.5 | 9.5 | 10.2 | 10.8 | 11.5 |
| Magnetic loss (50 MHz) | | | 0.04 | 0.06 | 0.09 | 0.12 | 0.10 | 0.08 |

**Table 1 - part 2**

| | | | Comparative Example | | | |
|---|---|---|---|---|---|---|
| | | | 1 | 2 | 3 | 4 |
| Resin composition No. | | | 7 | 8 | 9 | 10 |
| (A) Component | (A-1) Component | Magnetic powder a | 56 | | | |
| | (A-2) Component | Magnetic powder b | | 56 | | |
| | | Magnetic powder c | | | 70.5 | |
| | | Magnetic powder d | | | | 80.5 |
| (B) Component | (B-1) Component | Liquid epoxy resin a | 3 | 3 | 3 | 3 |
| | | Liquid epoxy resin b | 3 | 3 | 3 | 3 |
| | | Liquid epoxy resin c | 1 | 1 | 1 | 1 |
| | (B-2) Component | Curing accelerator a | 1 | 1 | 1 | 1 |
| a1 (% by volume) | | | 100 | 0 | 0 | 0 |
| a2 (% by volume) | | | 0 | 100 | 100 | 100 |
| a1 / a2 | | | - | - | - | - |
| Content of (A) component (% by volume) | | | 58 | 58 | 56 | 56 |
| Relative permeability (50 MHz) | | | 6.2 | 10.8 | 12.5 | 13 |
| Magnetic loss (50 MHz) | | | 0.05 | 0.20 | 0.22 | 0.18 |

| | | | | | | |
|---|---|---|---|---|---|---|
| * In the table, a1 represents the content (% by volume) of the (A-1) component relative to 100 % by volume of the total of the (A-1) component and the (A-2) component, and a2 represents the content (% by volume) of the (A-2) component relative to 100 % by volume of the total of the (A-1) component and the (A-2) component. | | | | | | |

As compared with Comparative Examples 1 to 4, in Examples 1 to 6, it can be seen that the relative permeability is higher, and the magnetic loss is decreased.

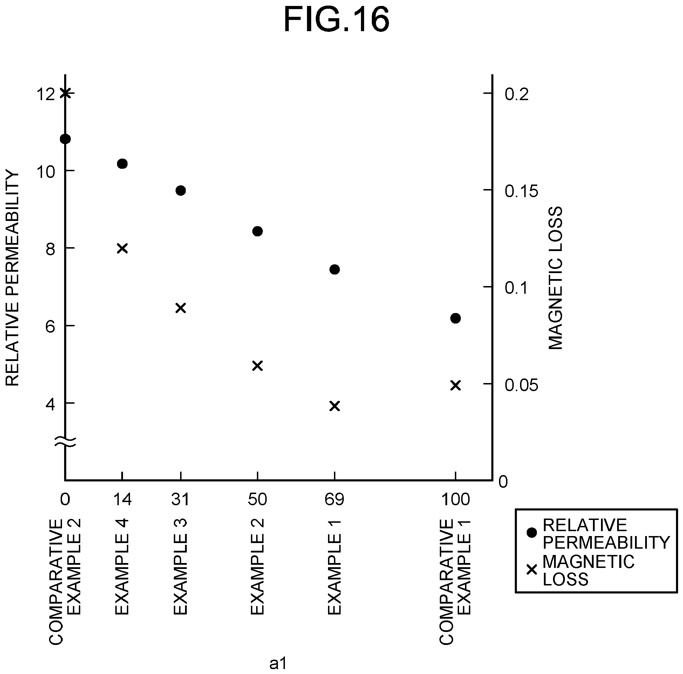

The relation of the content (% by volume) of the (A-1) component to the relative permeability and the magnetic loss in Examples 1 to 4 and Comparative Examples 1 to 2 is illustrated by the graph in Fig. 16. From Fig. 16, it can be seen that the relative permeability is increased in Examples 1 to 4 in which the (A-1) component and the (A-2) component are included, as compared with Comparative Example 1 in which the (A-2) component is not included. Also, it can be seen that in Examples 1 to 4, the magnetic loss is non-linearly decreased significantly as compared with Comparative Example 2 in which the (A-1) component is not included.

## Claims

1. A resin composition comprising:
a magnetic powder A-1;
a magnetic powder A-2; and
a resin component B;
**characterized in that**
the powder A-1 is a Mn-based ferrite having a powder compacting resistance within a range of 1.0×10⁵ Ω·cm to 1.0×10¹³ Ω·cm both ends inclusive;
the powder A-2 is at least one kind selected from a Mn-Zn-based ferrite, a Fe-Ni-based alloy, and a Fe-Si-based alloy, the powder A-2 having a powder compacting resistance within a range of 10 Ω·cm to 1.0×10⁴ Ω·cm both ends inclusive;
a1/a2 is in a range of 0.10 to 5.00 both ends inclusive, provided that a1 represents a content in % by volume of the powder A-1 relative to 100% by volume of a total of the powder A-1 and the powder A-2, and a2 represents a content in % by volume of the powder A-2 relative to 100% by volume of the total of the powder A-1 and the powder A-2, and
the powder compacting resistance is a volume resistivity of a compressed powder body measured at 25°C and humidity of 50%; the compressed powder body being obtained by press-molding 5 g of the magnetic powder, and filled in a measurement container with a load of 4 kN.

2. The resin composition according to claim 1, wherein a total content in % by volume of the powder A-1 and the powder A-2 relative to 100% by volume of non-volatile components in the resin composition is 50% or more by volume.

3. The resin composition according to claim 1 or 2, wherein the powder A-1 and the powder A-2 are soft magnetic powders.

4. The resin composition according to any one of claims 1 to 3, wherein the resin composition is for production of an inductor element.

5. The resin composition according to any one of claims 1 to 4, wherein the resin composition is in a paste-like form.

6. The resin composition according to any one of claims 1 to 5, wherein the resin composition is for filling of a through hole.

7. The resin composition according to any one of claims 1 to 6, wherein a relative permeability of a cured product of the resin composition at a frequency of 50 MHz is 5 or more.

8. The resin composition according to any one of claims 1 to 7, wherein a magnetic loss of a cured product of the resin composition at a frequency of 50 MHz is 0.15 or less.

9. A magnetic sheet comprising:
a support; and
a resin composition layer that is formed on the support and formed by using the resin composition according to any one of claims 1 to 8.

10. A circuit substrate comprising:
a substrate having a through hole; and
a cured product of the resin composition according to any one of claims 1 to 8 that is filled in the through hole.

11. A circuit substrate comprising a magnetic layer that is a cured product of the resin composition according to any one of claims 1 to 8.

12. An inductor substrate comprising the circuit substrate according to claim 10 or 11.

## Patentansprüche

1. Harzzusammensetzung, umfassend:
ein magnetisches Pulver A-1;
ein magnetisches Pulver A-2; und
eine Harzkomponente B;
**dadurch gekennzeichnet, dass**:
das Pulver A-1 ein Ferrit auf Mn-Basis mit einem Pulververdichtungswiderstand innerhalb eines Bereichs von 1,0 × 10⁵ Ω·cm bis 1,0 × 10¹³ Ω·cm, einschließlich beider Grenzwerte, aufweist;
das Pulver A-2 zumindest eine Art ist, die aus einem Ferrit auf Mn-Zn-Basis, einer Legierung auf Fe-Ni-Basis und einer Legierung auf Fe-Si-Basis ausgewählt ist, wobei das Pulver A-2 einen Pulververdichtungswiderstand innerhalb eines Bereichs von 10 Ω·cm bis 1,0 × 10⁴ Ω·cm, einschließlich beider Grenzwerte, aufweist;
a1/a2 im Bereich von 0,10 bis 5,00, einschließlich beider Grenzwerte, liegt, mit der Maßgabe, dass a1 für einen Gehalt in Vol.-% des Pulvers A-1 bezogen auf 100 Vol.-% einer Summe des Pulvers A-1 und des Pulvers A-2 steht und a2 für einen Gehalt in Vol.-% des Pulvers A-2 bezogen auf 100 Vol.-% der Summe des Pulvers A-1 und des Pulvers A-2 steht, und
wobei der Pulververdichtungswiderstand ein Volumenwiderstand eines verdichteten Pulverkörpers ist, der bei 25 °C und einer Feuchtigkeit von 50 % gemessen wird; wobei der verdichtete Pulverkörper durch Pressformen von 5 g des magnetischen Pulvers und Einfüllen in einen Messbehälter mit einer Belastung von 4 kN erhalten wird.

2. Harzzusammensetzung nach Anspruch 1, wobei ein Gesamtgehalt in Vol.-% des Pulvers A-1 und des Pulvers A-2 bezogen auf 100 Vol.-% von nichtflüchtigen Komponenten in der Harzzusammensetzung 50 Vol.-% oder mehr beträgt.

3. Harzzusammensetzung nach Anspruch 1 oder 2, wobei das Pulver A-1 und das Pulver A-2 weichmagnetische Pulver sind.

4. Harzzusammensetzung nach einem der Ansprüche 1 bis 3, wobei die Harzzusammensetzung zur Herstellung eines Spulenelements dient.

5. Harzzusammensetzung nach einem der Ansprüche 1 bis 4, wobei die Harzzusammensetzung in einer pastenähnlichen Form vorliegt.

6. Harzzusammensetzung nach einem der Ansprüche 1 bis 5, wobei die Harzzusammensetzung zum Füllen eines Durchgangslochs dient.

7. Harzzusammensetzung nach einem der Ansprüche 1 bis 6, wobei eine relative Durchlässigkeit eines gehärteten Produkts der Harzzusammensetzung bei einer Frequenz von 50 MHz 5 oder mehr beträgt.

8. Harzzusammensetzung nach einem der Ansprüche 1 bis 7, wobei ein magnetischer Verlust eines gehärteten Produkts der Harzzusammensetzung bei einer Frequenz von 50 MHz 0,15 oder weniger beträgt.

9. Magnetische Folie, umfassend:
einen Träger; und
eine Harzzusammensetzungsschicht, die auf dem Träger ausgebildet ist und unter Verwendung einer Harzzusammensetzung nach einem der Ansprüche 1 bis 8 ausgebildet ist.

10. Schaltkreissubstrat, umfassend:
ein Substrat, das ein Durchgangsloch aufweist; und
ein gehärtetes Produkt einer Harzzusammensetzung nach einem der Ansprüche 1 bis 8, das in das Durchgangsloch eingefüllt ist.

11. Schaltkreissubstrat, umfassend eine magnetische Schicht, die ein gehärtetes Produkt einer Harzzusammensetzung nach einem der Ansprüche 1 bis 8 ist.

12. Spulensubstrat, umfassend ein Schaltkreissubstrat nach Anspruch 10 oder 11.

## Revendications

1. Composition de résine, comprenant :
une poudre magnétique A-1 ;
une poudre magnétique A-2 ; et
un composant de résine B ;
**caractérisée en ce que**
la poudre A-1 est une ferrite à base de Mn présentant une résistance au compactage de poudre dans une plage de 1,0 × 10⁵ Ω ·cm à 1,0 × 10¹³ Ω·cm, y compris les deux extrémités ;
la poudre A-2 est au moins un type choisi parmi un ferrite à base de Mn-Zn, un alliage à base de Fe-Ni et un alliage à base de Fe-Si, la poudre A-2 présentant une résistance au compactage de poudre dans une plage de 10 Ω·cm à 1,0 × 10 ⁴, y compris les deux extrémités ;
a1/a2 est dans une plage de 0,10 à 5,00, y compris les deux extrémités, à condition que a1 représente une teneur en % en volume de la poudre A-1 par rapport à 100 % en volume d'un total de la poudre A-1 et de la poudre A-2, et a2 représente une teneur A-2 par rapport à 100 % en volume du total de la poudre A-1 et de la poudre A-2, et
la résistance au compactage de la poudre est une résistivité volumique d'un corps de poudre comprimée mesurée à 25°C et 50 % d'humidité ; le corps de poudre comprimée étant obtenu par moulage à la presse de 5 g de la poudre magnétique, et versé dans un récipient de mesure avec une charge de 4 kN.

2. Composition de résine selon la revendication 1, dans laquelle une teneur totale en % en volume de la poudre A-1 et de la poudre A-2 par rapport à 100 % en volume de composants non volatils dans la composition de résine est de 50 % en volume ou plus.

3. Composition de résine selon la revendication 1 ou 2, dans laquelle la poudre A-1 et la poudre A-2 sont des poudres magnétiques douces.

4. Composition de résine selon l'une quelconque des revendications 1 à 3, dans laquelle la composition de résine est destinée à la production d'un élément inducteur.

5. Composition de résine selon l'une quelconque des revendications 1 à 4, dans laquelle la composition de résine est sous une forme de pâte.

6. Composition de résine selon l'une quelconque des revendications 1 à 5, dans laquelle la composition de résine est destinée au remplissage d'un trou traversant.

7. Composition de résines selon l'une quelconque des revendications 1 à 6, dans laquelle une perméabilité relative d'un produit durci de la composition de résine à une fréquence de 50 MHz est de 5 ou plus.

8. Composition de résine selon l'une quelconque des revendications 1 à 7, dans laquelle une perte magnétique d'un produit durci de la composition de résine à une fréquence de 50 MHz est de 0,15 ou moins.

9. Feuille magnétique, comprenant :
un support ; et
une couche de composition de résine qui est formée sur le support et formée en utilisant la composition de résine selon l'une quelconque des revendications 1 à 8.

10. Substrat de circuit, comprenant :
un substrat présentant un trou traversant ; et
un produit durci de la composition de résine selon l'une quelconque des revendications 1 à 8 qui est versé dans le trou traversant.

11. Substrat de circuit comprenant une couche magnétique qui est un produit durci de la composition de résine selon l'une quelconque des revendications 1 à 8.

12. Substrat d'inducteur comprenant le substrat de circuit selon la revendication 10 ou 11.
